# EUROPEAN PATENT SPECIFICATION

(11) **EP 2 443 132 B1**
(45) Date of publication and mention of the grant of the patent: **10.10.2018**
(21) Application number: 10788586.5
(22) Date of filing: 18.05.2010
(51) Int. Cl.: C07F 17/02, C09K 11/06, H01L 51/50, H01L 51/54

(54) **PLATINUM (II) ISOQUINOLINE-PYRIDINE-BENZENE BASED COMPLEXES, PREPARING METHOD THEREOF, AND ORGANIC LIGHT-EMITTING DIODES MADE THEREFROM**
PLATIN-(II)-ISOCHINOLIN-PYRIDIN-BENZEN-BASIERTE KOMPLEXE, HERSTELLUNGSVERFAHREN DAFÜR UND ORGANISCHE LICHTEMITTIERENDE DIODEN DARAUS
COMPLEXES DE PLATINE (II) À BASE D'ISOQUINOLÉINE-PYRIDINE-BENZÈNE, LEUR PROCÉDÉ DE PRÉPARATION, ET DIODES ÉLECTROLUMINESCENTES ORGANIQUES PRÉPARÉES À PARTIR DE CES COMPLEXES

(30) Priority: 16.06.2009 US 485388
(43) Date of publication of application: 25.04.2012
(73) Proprietor: Versitech Limited, Hong Kong (CN)
(72) Inventor: CHE, Chiming, Hong Kong (CN); KUI, Chifai, Hong Kong (CN); KWOK, Chichung, Hong Kong (CN)
(74) Representative: Patentanwälte Ruff, Wilhelm, Beier, Dauster & Partner mbB
(86) International application number: PCT/CN2010/000696
(87) International publication number: WO 2010/145190

(56) References cited:
- WO-A1-2010/127307
- US-A1- 2008 309 227
- US-B2- 7 026 480
- KUI, STEVEN C. F. ET AL.: 'Structures, Photoluminescence, and Reversible Vapoluminescence Properties of Neutral Platinum(II) Complexes Containing Extended pi-Conjugated Cyclometalated Ligands' J. AM. CHEM. SOC. vol. 128, no. 25, 06 June 2006, pages 8297 - 8309, XP008149317
- GLENNA SO-MING TONG AND AL.: "Emissive or Nonemissive? A Theoritical Analysis of the Phosphorescence Efficiencies of Cyclometalated Platinum(II) Complexes", CHEM. EUR.J., vol. 15, 1 January 2009 (2009-01-01), pages 7225-7237,

## Description

### FIELD OF THE INVENTION

This invention relates novel platinum (II) complexes and their usage in organic light-emitting diodes (OLED). The platinum (II) complexes in the invention possess high emission quantum efficiency and good thermal stability. High efficiency single color and white OLEDs (WOLEDs) can be fabricated.

### BACKGROUND OF THE INVENTION

Organic electroluminescence was first observed and studied in the 1960's (U. S. Patent No. 3,172,862). In the 1980's, a double-layer structure OLEDs (organic light emitting device) was disclosed by Tang (U.S. Patent No. 4,356,429; Appl. Phys. Lett. 1987, 51, 12, 913). This discovery was based on employing a multilayer structure including an emissive electron-transporting layer and a hole-transport layer of suitable organic materials. Alq₃ (q = deprotonated 8-hydroxyquinolinyl) was chosen as the emissive electron-transporting material. Since then, research on materials used in OLEDs has continued. OLEDs provide several advantages including: (1) low operating voltage; (2) thin, monolithic structure; (3) emitting light, rather than modulating light; (4) good luminous efficiency; (5) full color potential; and (6) high contrast and resolution. These advantages suggest possible use of OLEDs in flat panel displays.

Investigations on organic small molecules have been made in order to improve the performance of OLEDs. In general, fluorescent and phosphorescent materials are employed as light emitters in the emissive layer of OLEDs. Light emission from a fluorescent compound occurs as a result of formation of singlet excitons in the emissive layer of the electroluminescent device. U.S. Published Patent App. No. 2003/178619 B2 disclosed that theoretically 25 % singlet excitons and 75 % triplet excitons are produced after recombination of holes and electrons in the emissive layer of an electroluminescent device. The singlet excitons transfer their energy to the singlet excited state while the triplet excitons transfer their energy to triplet excited state. Most of the organic small molecules exhibit fluorescence; hence, only 25 % of the generated excitons are utilized resulting in the device with low external efficiency.

Electroluminescence from conjugated polymers was first discovered by Friend et al. at Cambridge University during an investigation on the electrical properties of poly(p-phenylene vinylene) (PPV) in 1990 (Nature 1990, 347, 539). Yellow-green light with emission maximum at 551 nm was observed from this bright yellow polymer when excited by a flow of electric current between two electrodes. To deal with the solubility problem, Heeger et al. subsequently fabricated a PLED using soluble PPV derivative. (Appl. Phys. Lett. 1991, 1982).

As PLEDs can be used for large area flat panel displays and are relatively inexpensive, it has been receiving a growing attention in recent years. In the early stage, PLEDs were usually fabricated by spin coating. However, there are many disadvantages associated with this spin coating such as solution wastage and lack of lateral patterning capability, thus limiting the commercial applications of PLEDs. To overcome these drawbacks, inkjet printing has been introduced by Yang et al. (Appl. Phys. Lett. 1998, 2561) and now PLEDs can be fabricated using a commercial available inkjet printer.

In recent years, red-, green- and blue-light emitting polymers have been actively employed for the fabrication of full color panels. However, the commercial applications of the presently known polymers such as poly(p-phenylene) (PPP), PPV, polythiophene (PT), and polyfluorene (PF) are hampered by their oxidative stabilities and/or structural and electronic properties. Although PPV-based materials demonstrate high PL and EL efficiencies and their emission energies are tunable, they usually undergo photo-oxidative degradation upon incorporation into EL devices (Angew. Chem. Int. Ed. 1998, 37, 403). The applications of PPP are limited by its low solubility. PF is a blue-emitting material, which shows good thermal stability and high EL quantum efficiency, but chain aggregation and keto-defect sites in the polymer can cause degradation of EL devices (J. Mater. Chem. 2000, 10, 1471). Also, light-emitting polymers present technical problems in the fabrication of LEDs, including color impurity, imbalanced charge injection, and low EL efficiencies.
In contrast to fluorescent compounds, a series of effective phosphorescent iridium complexes with different color emissions has been reported jointly by Thompson et al. at the University of Southern California and Forrest et al. at Princeton University (U.S. Patent No. 6,515,298; J. Am. Chem. Soc. 2001, 123, 4304; Adv. Mat. 2001, 13, 1245). Che et al. also demonstrated the use of organic metal complexes employing various metal centers such as platinum (II), copper (I), gold (I), and zinc (II) as OLED emitters (U.S. Published Patent Application No. 2005/244672 A1; Chem. Eur. J. 2003, 9, 1263; Chem. Commun., 2002, 206; New J. Chem. 1999, 263; Appl. Phys. Lett., 1999, 74, 1361; Chem. Commun. 1998, 2101; Chem. Commun. 1998, 2491).

Recently, phosphorescent metal-organic materials, which have demonstrated a tremendous success in the development of high performance OLEDs through vacuum deposition process, have been attached to polymer backbones to make new class of light emitting polymers some of the recent examples are: Sky-blue emitting devices by Holdcroft et al. (Macromolecules 2006, 9157) and red-emitting devices by Cao et al. (Organometallics 2007, 26, 3699) In 2006, Thompson and co-workers reported high efficiency green light-emitting PLED with a maximum of external quantum efficiency (EQE) of 10.5 %. (Chem. Mater. 2006, 18, 386) Using this method, a near white light-emitting (CIE: 0.30, 0.43) PLED have been fabricated by using a polymer which has attached both blue and red emitting units on it (J. Am. Chem. Soc. 2004, 15388). As the polymeric materials used in the PLEDs have high molecular weight and soluble in common solvents, they are potential candidate for inkjet printing.

Organometallic complexes comprising an extended π-conjugated tridentate ligand having a platinum center in which chemical and/or physical properties of the complexes may be modified by changing the structure of the ligands are known from US 2008/0309227 A1.

### SUMMARY OF THE INVENTION

This invention relates to the preparation and application in organic light-emitting devices (OLEDs) of organometallic complexes having chemical structure of structure I: 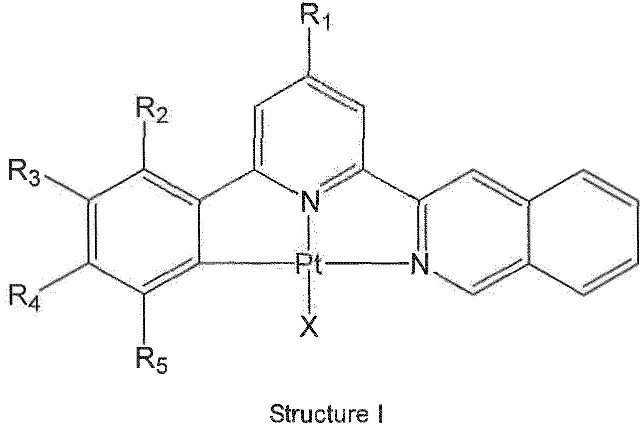 wherein R₁ - R₅ are independently hydrogen, halogen, hydroxyl, an unsubstituted alkyl, a substituted alkyl, cycloalkyl, an unsubstituted aryl, a substituted aryl, acyl, alkoxy, acyloxy, amino, nitro, acylamino, aralkyl, cyano, carboxyl, thio, styryl, aminocarbonyl, carbamoyl, aryloxycarbonyl, phenoxycarbonyl, or an alkoxycarbonyl group; X is halogen, 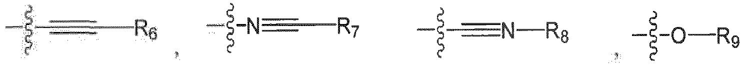 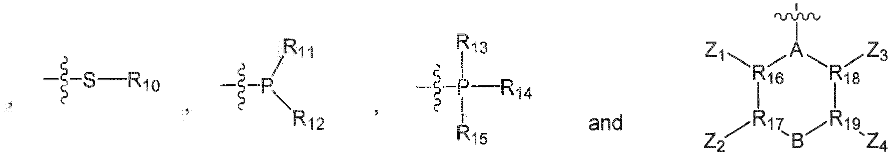 wherein A is carbon, nitrogen, oxygen, silicon, phosphorus, sulphur, arsenic and selenium; B is a chemical bonding connecting R₁₇ and R₁₉, 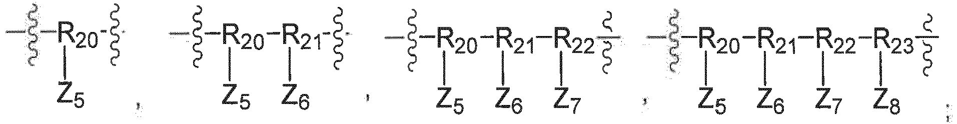 R₆-R₁₅ are independently hydrogen, alkyl, substituted alkyl, cycloalkyl, aryl, and substituted aryl group; R₁₆ - R₂₃ are independently carbon, nitrogen, oxygen, silicon, phosphorus, sulphur, arsenic and selenium; Z₁ - Z₈ are independently hydrogen, alkyl, substituted alkyl, cycloalkyl, aryl, substituted aryl group and Z₁ - Z₈ can form 5 - 7 member ring(s) with neighboring groups. The invention also provides ligands useful for making such complexes.

The invention further provides a method for making such organic metallic complexes, OLEDs incorporating same and methods for making such OLEDs.

The invention also provides compositions useful in making organic metallic complexes, methods for making such complexes, OLEDS including such complexes, and methods for making such OLEDS.

For the purposes of the present application, the terms halogen, alkyl, cycloalkyl, aryl, acyl and alkoxy may have the following meanings:
The halogen or halo used herein includes fluorine, chlorine, bromine and iodine, preferably F, Cl, Br, particularly preferably F or Cl.

The aryl group or aryl moiety as used herein includes aryl having from 6 to 30 carbon atoms, preferably from 6 to 18 carbon atoms, and is made up of an aromatic ring or a plurality of fused aromatic rings. Suitable aryls are, for example, phenyl, naphthyl, acenaphthenyl, acenaphthylenyl, anthracenyl, fluorenyl, phenalenyl, phenanthrenyl. This aryl can be unsubstituted (i.e. all carbon atoms which are capable of substitution bear hydrogen atoms) or be substituted on one, more than one or all substitutable positions of the aryl. Suitable substituents are halogen, preferably F, Br or Cl, alkyl radicals, preferably alkyl radicals having from 1 to 8 carbon atoms, particularly preferably methyl, ethyl, i-propyl or t-butyl, aryl radicals, preferably C₆-aryl radicals or fluorenyl, which may once again be substituted or unsubstituted, heteroaryl radicals, preferably heteroaryl radicals containing at least one nitrogen atom, particularly preferably pyridyl radicals, alkenyl radicals, preferably alkenyl radicals which have one double bond, particularly preferably alkenyl radicals having a double bond and from 1 to 8 carbon atoms, or groups having a donor or acceptor action. For the purposes of the present invention, groups having a donor action are groups which display a +1 and/or +M effect, and groups having an acceptor action are groups which display a -I and/or -M effect. Suitable groups having a donor or acceptor action are halogen radicals, preferably F, Cl, Br, particularly preferably F, alkoxy radicals, carbonyl radicals, ester radicals, amine radicals, amide radicals, CH₂F groups, CHF₂ groups, CF₃ groups, CN groups, thio groups or SCN groups. The aryl radicals very particularly preferably bear substituents selected from the group consisting of methyl, F, Cl and alkoxy, or the aryl radicals are unsubstituted. Preference is given to the aryl radical or the aryl group being a C₆-aryl radical which may optionally be substituted by at least one of the abovementioned substituents. The C₆-aryl radical particularly preferably bears none, one or two of the abovementioned substituents, with the one substituent preferably being located in the para position relative to the further linkage point of the aryl radical and, in the case of two substituents, these are each located in the meta position relative to the further linkage point of the aryl radical. The C₆-aryl radical is very particularly preferably an unsubstituted phenyl radical. The aryl or aryl moiety as used herein is preferably fluorenyl or phenyl, which may be unsubstituted or substituted by the abovementioned substituents, preferably halogen, alkyl or unsubstituted or substituted fluorenyl as used herein.

The alkyl or alkyl moiety used herein includes alkyl having from 1 to 20 carbon atoms, preferably from 1 to 10 carbon atoms, particularly preferably from 1 to 6 carbon atoms.

This alkyl can be branched or unbranched and may be interrupted by one or more heteroatoms, preferably N, O or S. Furthermore, this alkyl may be substituted by one or more of the substituents mentioned in respect of the aryl groups. For example, possible substituted alkyl includes trifluoromethyl group. It is likewise possible for the alkyl radical to bear one or more aryl groups. All the mentioned aryl groups are suitable for this purpose. The alkyl radicals are particularly preferably selected from the group consisting of methyl, ethyl, i-propyl, n-propyl, i-butyl, n-butyl, t-butyl, sec-butyl, i-pentyl, n-pentyl, sec-pentyl, neopentyl, n-hexyl, i-hexyl and sec-hexyl. Very particular preference is given to methyl, i-propyl and n-hexyl.

The cycloalkyl as used herein contemplates cyclic alkyl radicals. Preferred cycloalkyl groups are those containing 3 to 7 carbon atoms and includes cyclopropyl, cyclopentyl, cyclohexyl, and the like. Additionally, the cycloalkyl group may be optionally substituted with one or more substituents selected from halo, CN, CO₂R, C(O)R, NR₂, cyclic-amino, NO₂, and OR.

The acyl as used herein is an alkyl group as used herein that is attached to the CO group with a single bond.

The alkoxy is an alkyl group as used herein linked to oxygen.

### BRIEF DESCRIPTION OF DRAWINGS AND FIGURES

Further features and advantages of the invention will become apparent by reviewing the following detailed description of the preferred embodiments, taken in conjunction with the attached drawings in which:
Figure 1 is a schematic drawing of a configuration of organic light-emitting diode;
Figure 2 is a current density, voltage and brightness (J-V-B) relationship graph for device A;

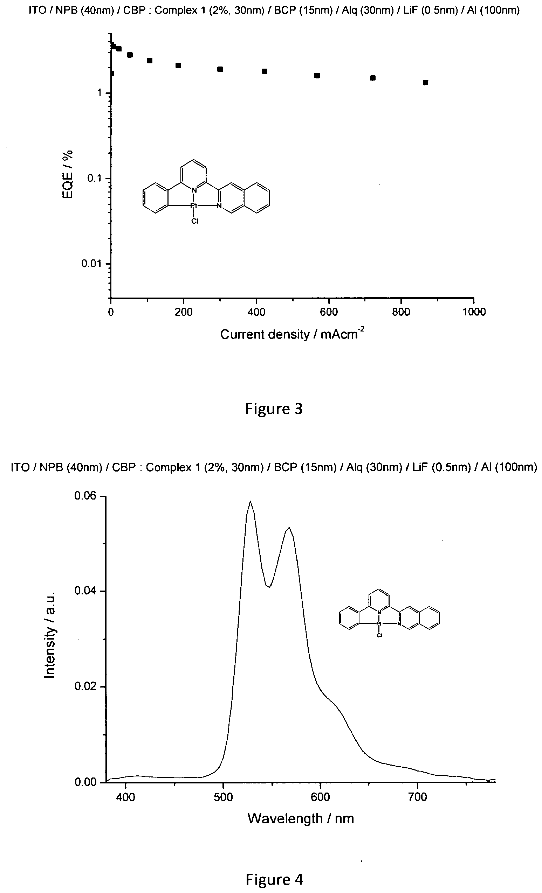

Figure 3 is an external quantum efficiency, current density relation graph for device A.
Figure 4 is an electroluminescence spectrum for device A;

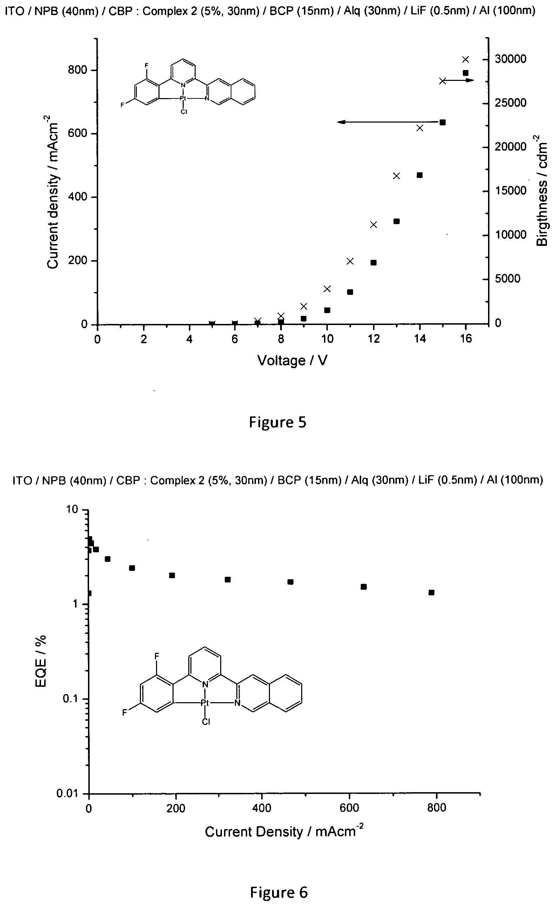

Figure 5 is a current density, voltage and brightness (J-V-B) relationship graph for device B;
Figure 6 is an external quantum efficiency, current density relation graph for device B;

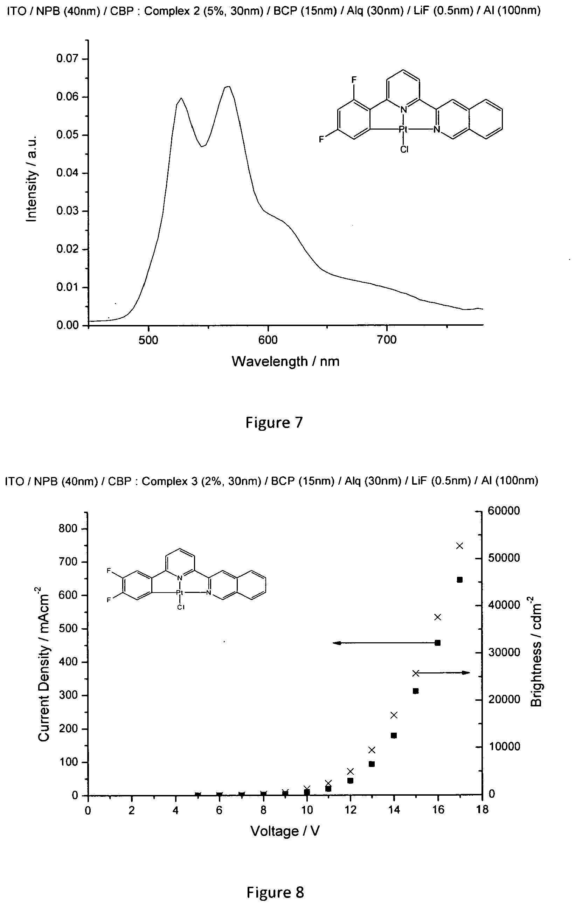

Figure 7 is an electroluminescence spectrum for device B;
Figure 8 is a current density, voltage and brightness (J-V-B) relationship graph for device C;

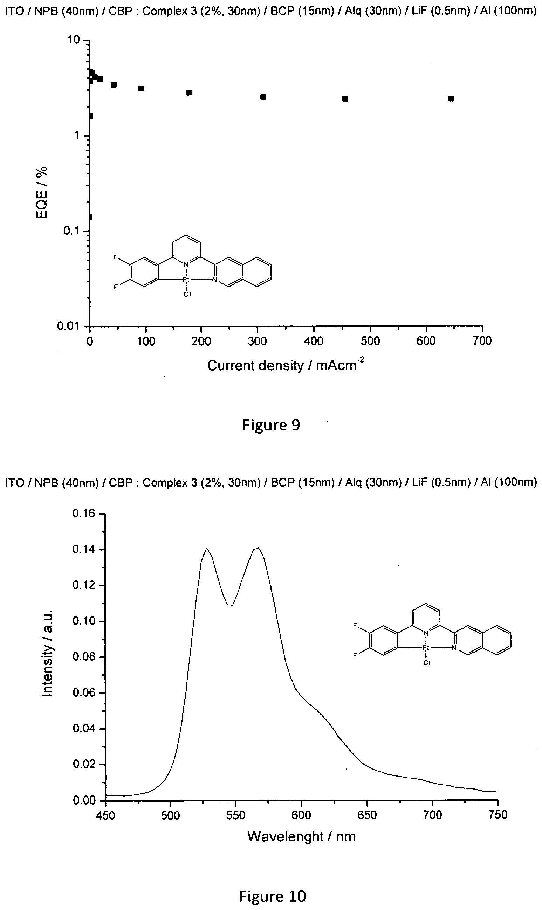

Figure 9 is an external quantum efficiency, current density relation graph for device C;
Figure 10 is an electroluminescence spectrum for device C;

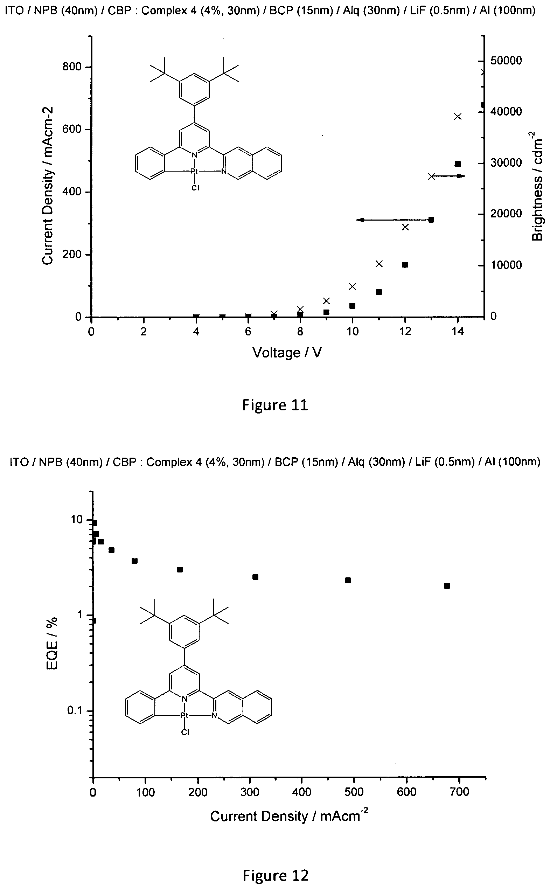

Figure 11 is a current density, voltage and brightness (J-V-B) relationship graph for device D;
Figure 12 is an external quantum efficiency, current density relation graph for device D;

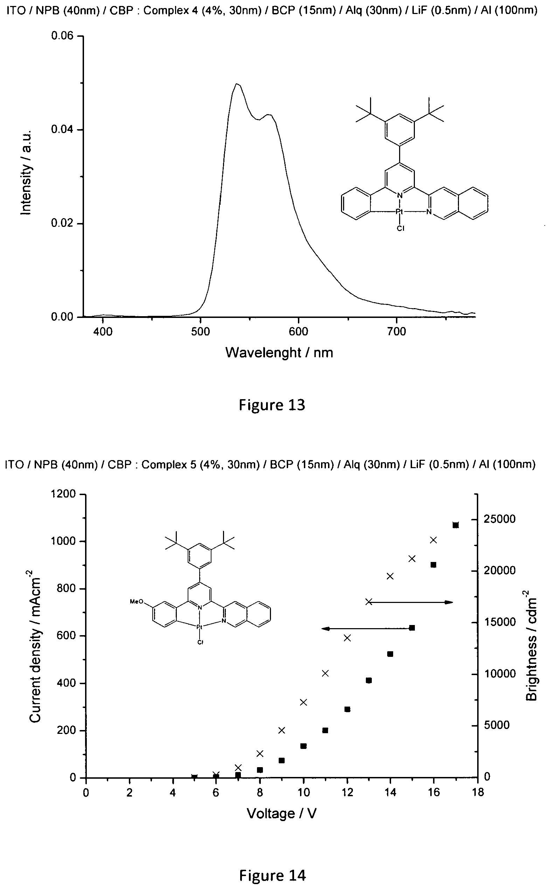

Figure 13 is an electroluminescence spectrum for device D;
Figure 14 is a current density, voltage and brightness (J-V-B) relationship graph for device E;

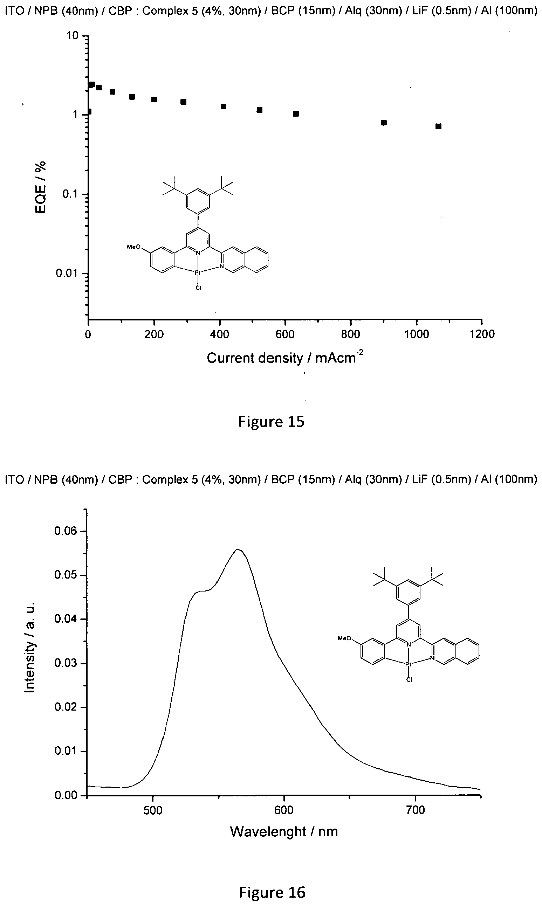

Figure 15 is an external quantum efficiency, current density relation graph for device E;
Figure 16 is an electroluminescence spectrum for device E;

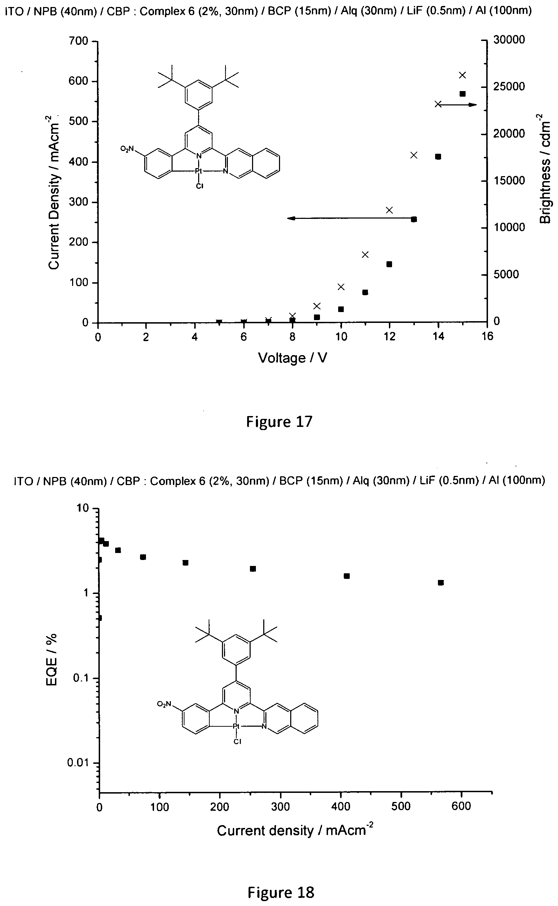

Figure 17 is a current density, voltage and brightness (J-V-B) relationship graph for device F;
Figure 18 is an external quantum efficiency, current density relation graph for device F.

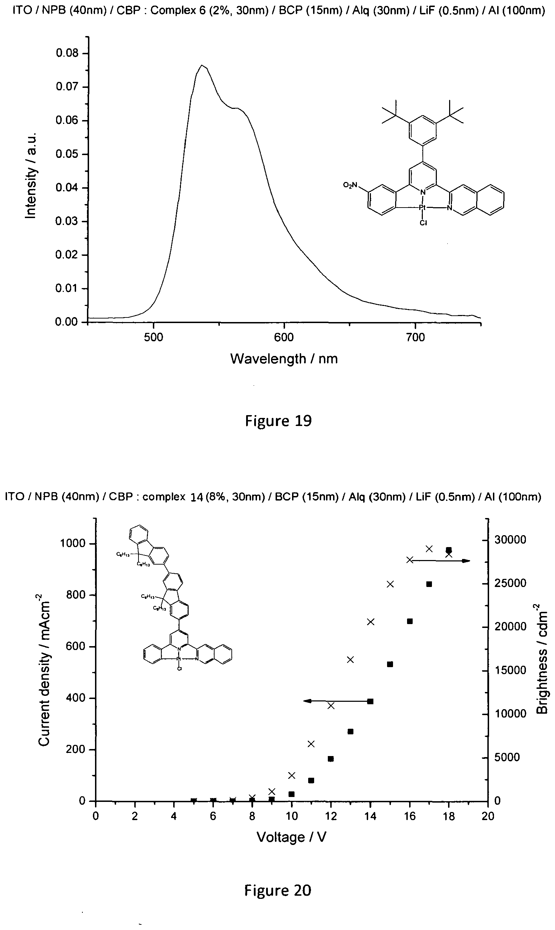

Figure 19 is an electroluminescence spectrum for device F;
Figure 20 is a current density, voltage and brightness (J-V-B) relationship graph for device G;
Figure 21 is an external quantum efficiency, current density relation graph for device G;
Figure 22 is an electroluminescence spectrum for device G;
Figure 23 is a current density, voltage and brightness (J-V-B) relationship graph for device H;
Figure 24 is external quantum efficiency, current density relation graph for device H;

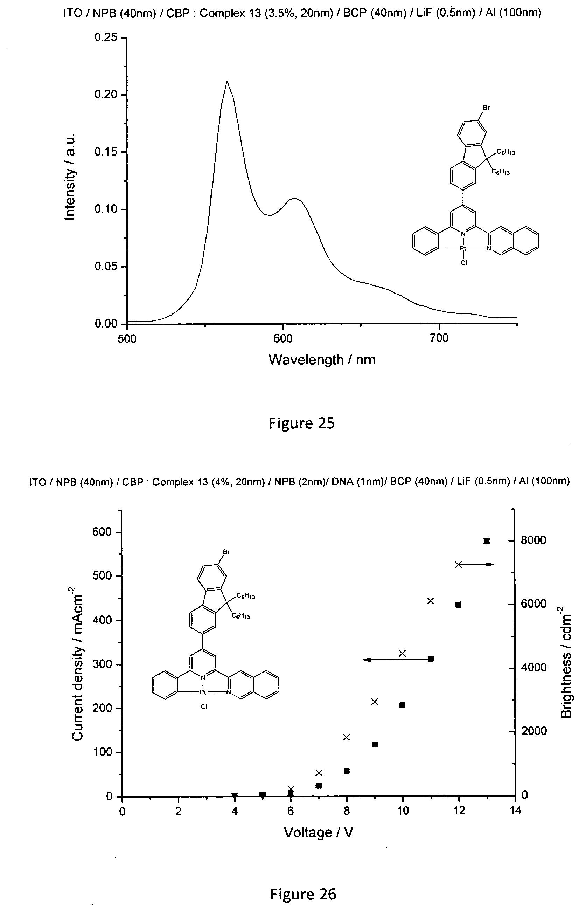

Figure 25 is an electroluminescence spectrum for device H;
Figure 26 is a current density, voltage and brightness (J-V-B) relationship graph for device I;

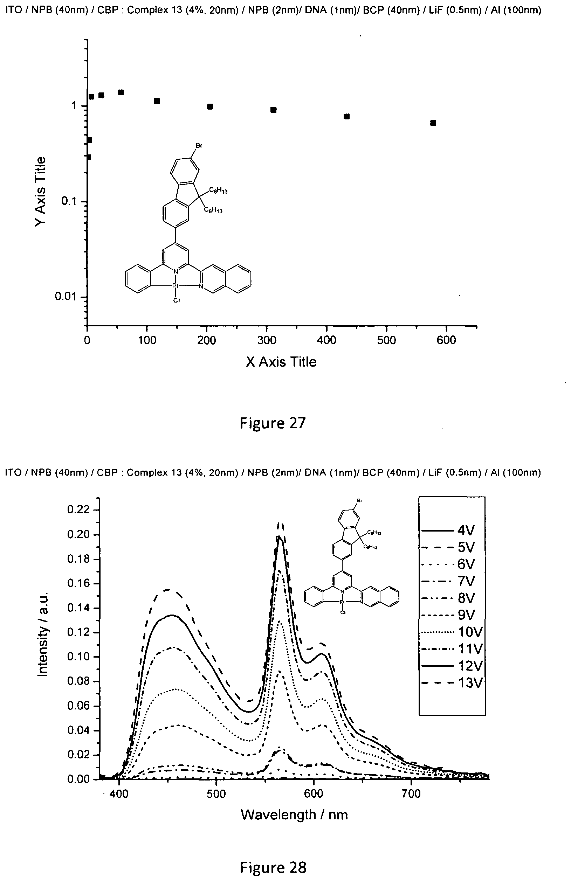

Figure 27 is external quantum efficiency, current density relation graph for device I; and
Figure 28 is an electroluminescence spectrum for device I.

### DETAILED DESCRIPTION OF INVENTION

The organometallic complexes with the chemical structure of Structure I are referred to as cyclometallated complexes. The platinum center in Structure I (see above) is in +2 oxidation state and has a square planar geometry.

The coordination sites of the platinum center are occupied by one tridentate ligand and one mono-dentate ligand. The tridentate ligand coordinates to the platinum center through two nitrogen donor bonds and a metal-carbon bond where the nitrogen donors are from pyridine and isoquinoline groups and the metal-carbon bond is formed by benzene or substituted benzene and platinum. The tridentate ligand bears a formal negative charge localized at the site of a metal-carbon bond.

The tridentate ligand is represented by Structure II: 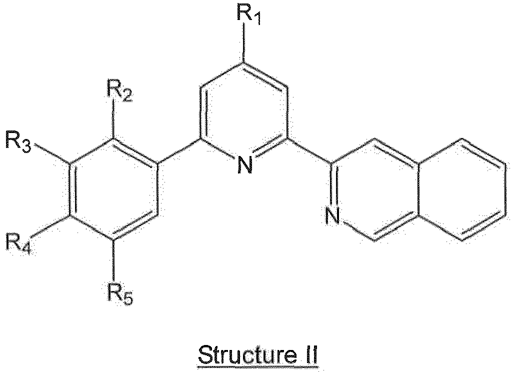 wherein R₁ - R₅ are independently hydrogen, halogen, hydroxyl, an unsubstituted alkyl, a substituted alkyl, cycloalkyl, an unsubstituted aryl, a substituted aryl, acyl, alkoxy, acyloxy, amino, nitro, acylamino, aralkyl, cyano, carboxyl, thio, styryl, aminocarbonyl, carbamoyl, aryloxycarbonyl, phenoxycarbonyl, or an alkoxycarbonyl group.

Representative examples of the tridentate ligand are shown below:

| | |
|---|---|
| 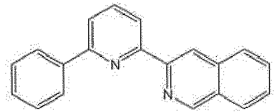 | 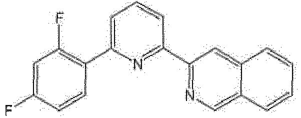 |
| Ligand 1 | Ligand 2 |
| 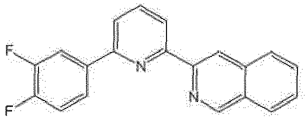 | 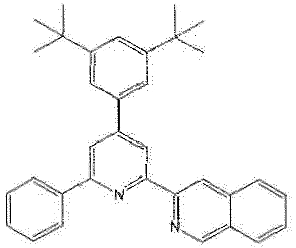 |
| Ligand 3 | Ligand 4 |
| 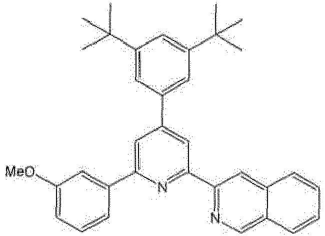 | 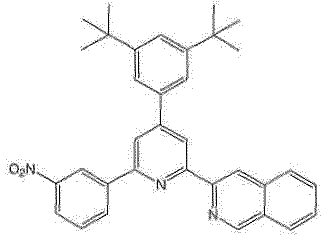 |
| Ligand 5 | Ligand 6 |
| 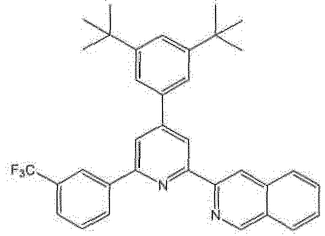 | 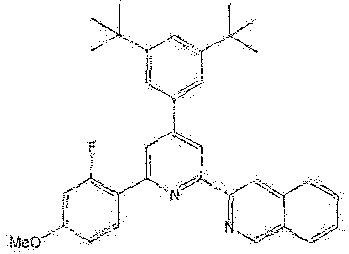 |
| Ligand 7 | Ligand 8 |
| 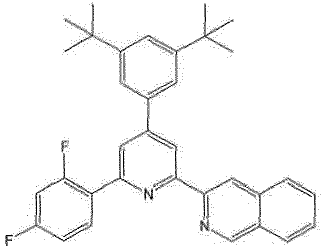 | 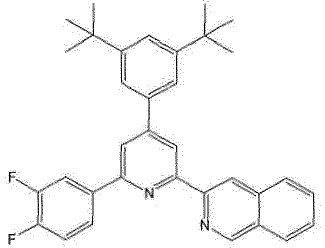 |
| Ligand 9 | Ligand 10 |
| 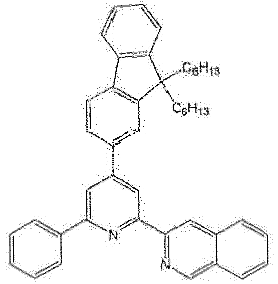 | 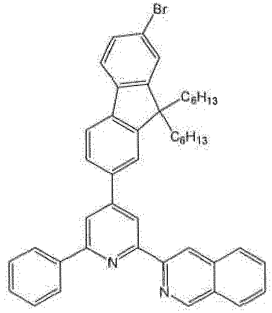 |
| Ligand 11 | Ligand 12 |
| 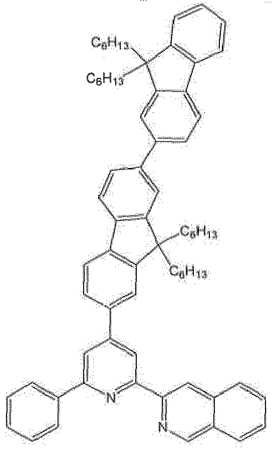 | |
| Ligand 13 | |

Representative examples of the platinum (II) complexes (Complexes 1 - 16) based on Structure I are shown below:

| | |
|---|---|
| 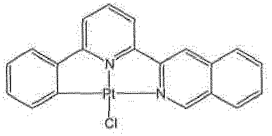 | 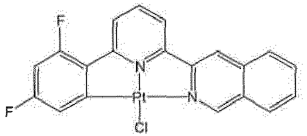 |
| Complex 1 | Complex 2 |
| 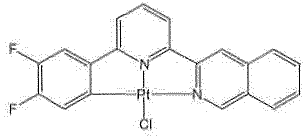 | 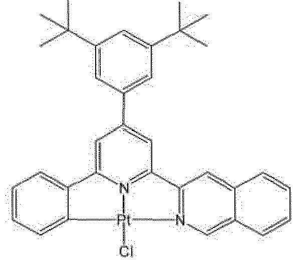 |
| Complex 3 | Complex 4 |
| 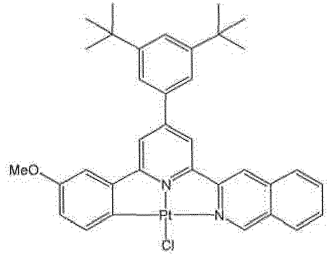 | 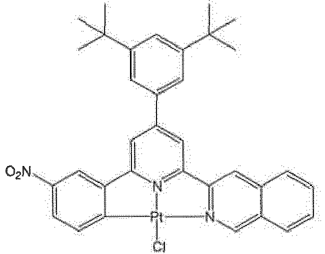 |
| Complex 5 | Complex 6 |
| 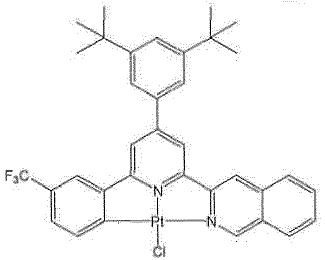 | 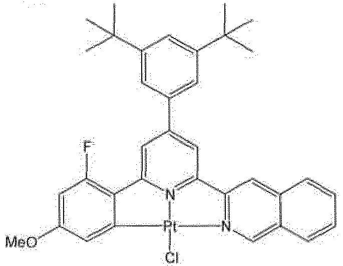 |
| Complex 7 | Complex 8 |
| 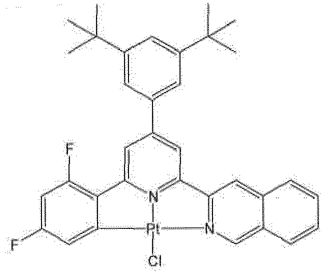 | 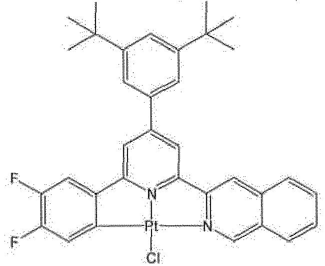 |
| Complex 9 | Complex 10 |
| 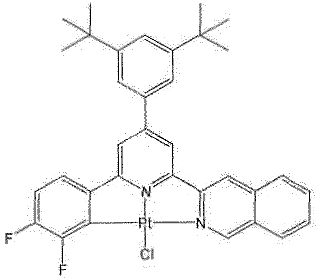 | 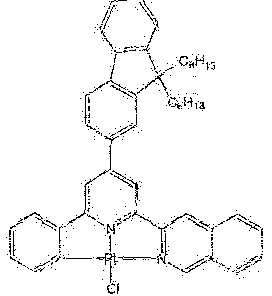 |
| Complex 11 | Complex 12 |
| 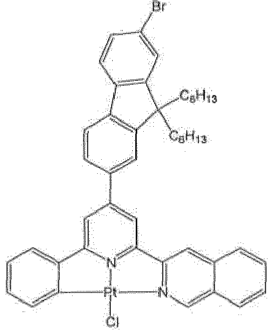 | 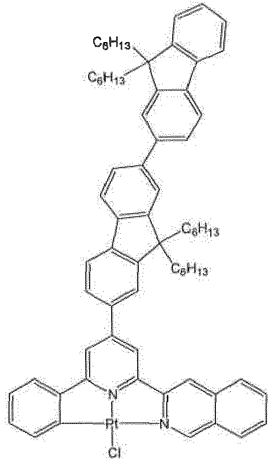 |
| Complex 13 | Complex 14 |
| 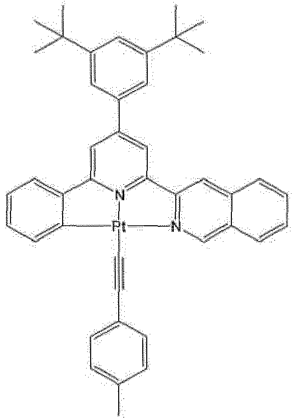 | 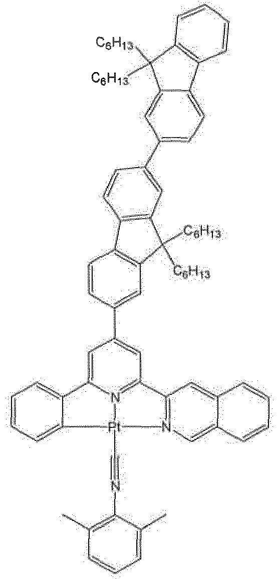 |
| Complex 15 | Complex 16 |

In preferred embodiments, there is a general method for preparing platinum (II) complexes with corresponding ligands (Ligands 1 - 13) in the representative examples. To prepare of these platinum (II) complexes a mixture of potassium tetrachloroplatinate (K₂PtCl₄) and ligand (Ligands 1 - 13) in glacial acetic acid was refluxed for 24 hours gave a yellow suspension. The yellow solid was washed with water and acetone, and recrystallized in CH₂Cl₂ or DMF. Reaction I below illustrates the preferred use of acetic acid as solvent in forming neutral platinum complexes.

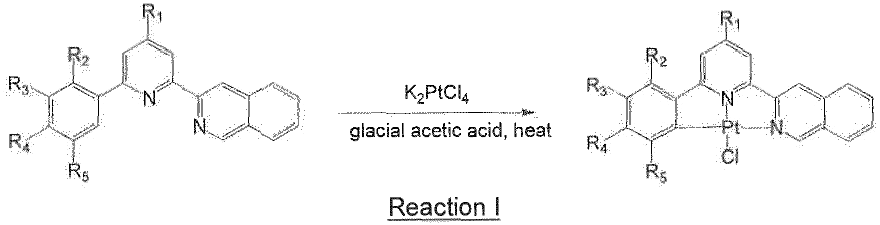

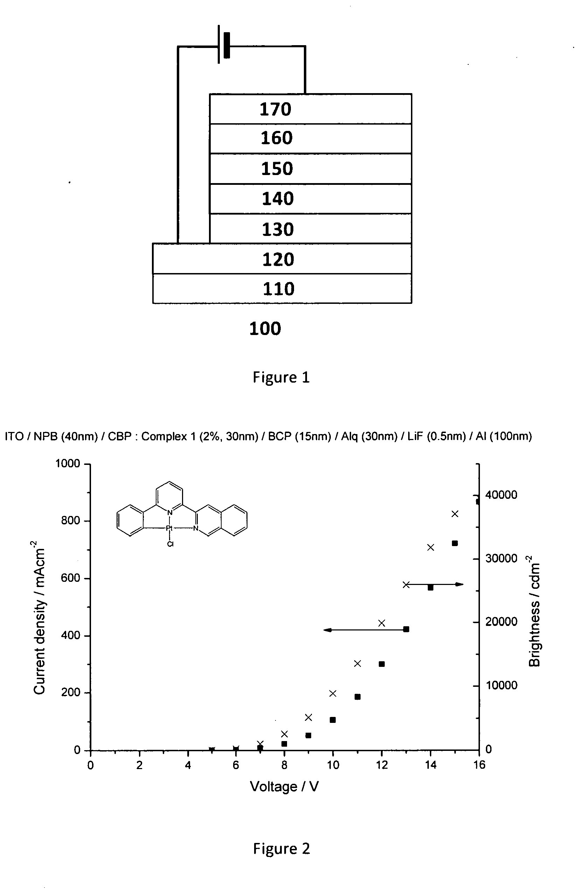

The present invention also relates to OLED comprising at least one emissive layer containing organometallic complex with chemical structure of Structure I. The organic light-emitting device according to the present invention may comprise (preferably in sequence): a transparent substrate; a transparent electrode; a hole transporting layer; an emissive layer comprising a host material doped with least one of the organometallic complex according to the present invention; a hole blocking layer; an electron transporting layer; a charge injection layer; and an electrode. The organic light-emitting device according to the present invention may comprise (preferably in sequence): a transparent substrate; a transparent electrode; a hole transporting layer; an emissive layer comprising a host material doped with at least one of the organometallic complexes according to the present invention; a hole transporting layer; an emissive layer comprising a blue to sky blue emitting material; a hole blocking layer; a charge injection layer; and an electrode. As shown in Figure 1, a typical device 100 has a transparent anode layer 120; a cathode layer 170; emissive layer 140; optional hole transporting layer 130; optional hole blocking layer 150 and optional electron transporting layer 160. Layer 110 is transparent substrate. The transparent substrate as used herein can be glass or plastic; rigid or flexible substrate.

The organometallic complexes of the invention are used in emissive layer 140. Layer 140 can be purely comprised of organometallic complex in the invention (100 weight % of organometallic complex) or mixing with host material in certain weight %. Preferably, the host material transport hole and/or electron and have wider band gap than the organometallic complexes in the invention. The host material can be polymeric material such as but not limited to poly (N-vinyl carbazole), polysilane and polyfluorene. It can also be a small molecule such as but not limited to CBP (4,4'-N,N'-dicarbazole-biphenyl) or tertiary aromatic amines.

The transparent anode layer as used herein such as layer 120 can comprise or can be made of materials containing metal, alloy, metal oxide or mixed-metal oxide such as indium-tin-oxide.

The hole transport layer as used herein such as layer 130 can comprise or is fabricated by organic materials such as but not limited to TPD (N,N'-Bis(3-methylphenyl)-N,N'-diphenylbenzidine), NPB (N,N'-di-1-naphthyl-N,N'-diphenyl-benzidine), TAPC (1,1-bis[(di-4-tolylamino)phenyl]cyclohexane), ETPD (N,N'-bis(4-methylphenyl)-N,N'-bis(4-ethylphenyl)-[1,1'-(3,3'-dimethyl)biphenyl]4,4'-di amine, CuPc (copper phthalocyanine), PVK (polyvinylcarbazole) and PEDOT (poly(3,4-ethylendioxythiophene).

The hole blocking layer as used herein such as layer 150 can comprise or is fabricated from organic materials with high electron mobility and low HOMO (highest occupied molecular orbital) level such as but not limited to BCP (2,9-dimethyl-4,7-diphenyl-1,10-phenanthroline, bathocuproine) and BAlq₃ (*bis*(2-methyl-8-quinolinolato)(4-phenylphenolato)aluminum).

The electron transporting layer as used herein such as layer 160 can comprise or is fabricated by organic materials with high electron mobility such as but not limited to Alq₃ (*tris*(8-quinolinolato)aluminum), BAlq₃ (*bis*(2-methyl-8-quinolinolato)(4-phenylphenolato)aluminum), PBD (2-(4-biphenylyl)-5-(4-*tert*-butylphenyl)-1,3,4-oxadiazole) and TAZ (3-(4-biphenylyl)-4-phenyl-5-(4-*tert*-butylphenyl)-1,2,4-triazole).

The cathode as used herein such as layer 170 can comprise or is fabricated by low work function metal such as but not limited to Ca, Al and Ba. The electrode as used herein can comprise the cathode as used herein and/or anode as used herein.

### Examples

A number of examples are listed below to further illustrate the invention. They should not be construed to limit the invention in any way.

### Example 1

### Synthetic procedure for Ligand 1:

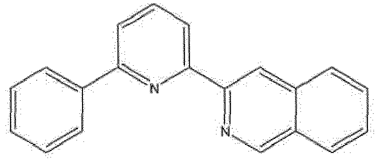

Refluxing a methanol (100 mL) solution of 1.00 g (2.64 mmol) 1-(2-oxo-2-(3'-isoquinolinyl) ethyl) pyridinium iodide, 0.60 g (2.81 mmol) 3-Dimethylamino-1-(2'-pyridinyl)-propanone hydrochloride salt and 5.00 g (64.9 mmol) ammonium acetate for 24 hours give a suspension solution. The crude product was filtered from the solution mixture, washed with water and cold methanol, and purified by column chromatography. Yield: 0.64 g (86.0 %). ¹H NMR (500 MHz, CDCl₃) δ = 7.45 (t, *J* = 7.2 Hz, 1H), 7.55(t, *J* = 7.2 Hz, 2H), 7.63 (t, *J* = 7.3 Hz, 1H), 7.65 (t, *J* = 7.8 Hz 1H), 7.78 (d, *J* = 7.5 Hz, 1H), 7.93 (t, *J* = 7.8 Hz, 1H), 8.02 (d, *J* = 8.6 Hz, 2H), 8.21 (d, *J* = 6.3 Hz, 2H), 8.49 (d, *J* = 7.8 Hz, 1H), 9.01 (s, 1H), 9.34 (s, 1H). EI-MS (+ve, m/z): 282 [M⁺].

### Example 2

### Synthetic procedure for Ligand 2:

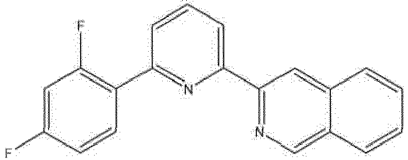

A solution of 3-acetylisoquinoline (0.84 g, 4.94 mmol) and potassium tert-butoxide (0.83 g, 7.40 mmol) in THF (30 ml) was stirred for 2 hr at room temperature to give a yellow suspension. A solution of 1-*N*,*N*-dimethylamino-3-(2',4'-difluorophenyl) -3-oxo-1-propene (1.04g, 4.94 mmol) in THF (20 ml) was then added and the mixture was stirred for 12 hr at room temperature to give a dark red solution. A solution of ammonium acetate (26.0 g, 0.34 mol) in acetate acid (100 ml) was added to the mixture. THF was removed by distillation over 2 hr and the residue was dried under vacuum. Dichloromethane (50 ml) was added to yield a red solution, which was neutralized with saturated sodium bicarbonate solution then extracted with CH₂Cl₂. The organic extract was dried over sodium sulphate. Purification was performed by silica gel chromatography using n-hexane: ethyl acetate (9:1) as eluent to give pale yellow solid. Yield: 0.94 (60%) ¹H NMR (500 MHz, CDCl₃) δ = 7.09 (m, 1H), 7.11 (m, 1H), 7.62 (t, *J* = 5.51 Hz, 1H), 7.71 (t, *J* = 8.05 Hz, 1H), 7.78 (d, *J* = 7.78 Hz, 1H), 7.92 (t, *J* = 7.83 Hz, 1H), 8.00 (d, *J* = 8.30 Hz, 1H), 8.01 (d, 8.2 Hz, 1H), 8.26 (m, 1H), 8.50 (d, *J* = 7.6 Hz, 1H), 8.90 (s, 1H), 9.34 (s, 1H). EI-MS (+ve, m/z): 319.2[M⁺].

### Example 3

### Synthetic procedure for Ligand 3:

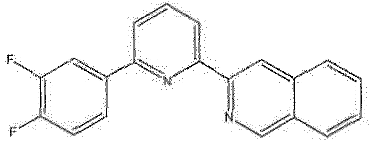

A solution of 3-acetylisoquinoline (1.00 g, 5.84 mmol) and potassium tert-butoxide (0.98 g, 8.76 mmol) in THF (30 ml) was stirred for 2 hr at room temperature to give a yellow suspension. A solution of 1-*N*,*N*-dimethylamino-3-(3',4'-difluorophenyl)-3-oxo-1-propene (1.23g, 5.84 mmol) in THF (20 ml) was then added and the mixture was stirred for 12 hr at room temperature to give a dark red solution. A solution of ammonium acetate (26.0 g, 0.34 mol) in acetate acid (100 ml) was added to the mixture. THF was removed by distillation over 2 hr and the residue was dried under vacuum. Dichloromethane (50 ml) was added to yield a red solution, which was neutralized with saturated sodium bicarbonate solution then extracted with CH₂Cl₂. The organic extract was dried over sodium sulphate. Purification was performed by silica gel chromatography using n-hexane: ethyl acetate (9:1) as eluent to give pale yellow solid. Yield: 0.93 g (50 %). ¹H NMR (500 MHz, CDCl₃, 25°C). δ = 7.32 (q, 1H), 7.65 (t, 1H), 7.72 (d, 1H), 7.75 (t, 1H), 7.90 (m, 1H), 8.00 (t, 2H), 8.11 (t, 1H), 8.51 (d, 1H), 8.96 (s, 1H), 9.34 (s, 1H). ¹³C NMR (150 MHz, CDCl₃, 25 °C): δ = 156.3, 154.4, 152.1, 149.7, 140.0, 136.6, 130.6, 128.9, 127.8, 127.7, 127.6, 122.9(3), 122.8, 120.0, 119.6, 117.8, 117.4 (d, *J =* 17.25 Hz), 116.1 (d, *J =* 18.15 Hz) EI-MS (+ve, m/z): 319.1 [M⁺].

### Example 4

### General synthetic procedures for Ligands 4 - 10.

Refluxing a methanol mixture of 1-(2-oxo-2-(3'-isoquinolinyl) ethyl) pyridinium iodide, excess ammonium acetate and the corresponding α,β-unsaturated ketone for 24 hours gave a suspension mixture. The crude product was filtered from the solution mixture, washed with water and cold methanol, and purified by column chromatography (silica gel, *n*-hexane/Et₂O = 8:1 as eluent).

### Example 5

### Synthetic procedure for Ligand 4:

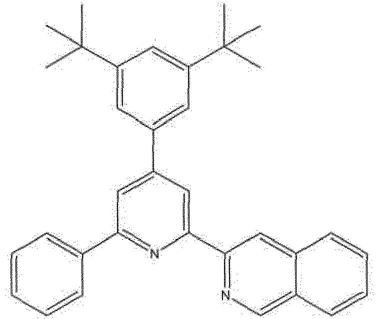

Ligand 4 was synthesized by general procedures in Example 4 with 1.00 g (2.64 mmol) 1-(2-oxo-2-(3'-isoquinolinyl)ethyl)pyridinium iodide, 0.85 g (2.65 mmol) 3',5'-di-tert-butylbenzylidene-2-acetophenone, 5.00g (64.9 mmol) ammonium acetate and 100 mL methanol. Ligand 4 was obtained as yellow solid. Yield 1.11 g (89.0 %). ¹H NMR (500 MHz, CDCl₃, 25 °C) δ = 1.47 (s, 18H), 7.51 (m, 1H), 7.58 (m, 3H), 7.65 (t, *J* = 7.8 Hz, 3H), 7.75 (t, *J* = 7.8 Hz, 1H,), 7.90 (s, 1H), 8.01 (m, 2H), 8.23 (d, *J* = 7.5 Hz, 2H), 8.80 (s, 1H), 9.10 (s, 1H), 9.32 (s, 1H). ¹³C NMR (500 MHz, CDCl₃, 25 °C): δ = 31.6, 35.1, 118.1, 118.3, 118.9, 121.7, 123.1, 127.3, 127.5, 127.6, 127.8, 128.3, 128.6, 128.8, 129.0, 130.5, 133.1, 136.7, 138.7, 139.9, 150.3, 151.9. 152.0, 156.5. EI-MS (+ve, m/z): 471 [M⁺].

### Example 6

### Synthetic procedure for Ligand 5:

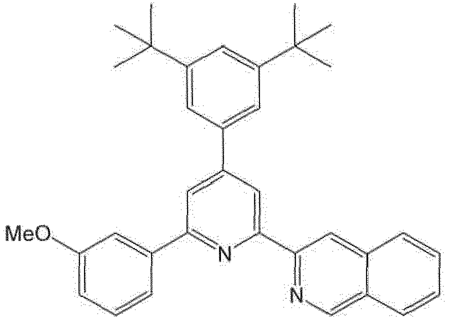

Ligand 5 was synthesized by general procedures in Example 4 with 0.75 g (1.97 mmol) 1-(2-oxo-2-(3'-isoquinolinyl) ethyl) pyridinium iodide, 0.69 g (1.97 mmol) 3',5'-di-tert-butylbenzylidene-2-(1-aceto-3-methoxyphenone), 5.00g, (64.9 mmol) ammonium acetate and 100 mL methanol. Ligand 5 was obtained as yellow solid. Yield 0.81 g (82.0 %). ¹H NMR (500MHz, CDCl₃, 25°C) δ = 1.47 (s, 18H), 3.97 (s, 3H), 7.10 (d, *J* = 9.4 Hz, 1H), 7.52 (t, *J* = 7.8 Hz,1H), 7.61 (s, 1H), 7.65 (s, 2H), 7.68 (t, *J* = 7.8 Hz, 1H), 7.79 (t, *J* = 7.8 Hz, 1H), 7.82 (d, *J* = 7.5 Hz, 1H), 7.87 (s, 1H), 7.97 (s, 1H) , 8.04 (d, *J* = 8.6 Hz, 2H), 8.72 (s, 1H), 9.00 (s, 1H), 9.35 (s, 1H). ¹³C NMR (500 MHz, CDCl₃, 25 °C): δ = 31.6, 35.1, 55.5, 113.2, 114.3, 118.1, 118.5, 119.1, 119.8, 121.7, 123.1, 127.5, 127.6, 127.8, 128.8, 129.8, 130.5, 136.7, 138.7, 141.5, 150.3, 151.6, 151.9, 152.0. EI-MS (+ve, m/z): 501 [M⁺].

### Example 7

### Synthetic procedure for Ligand 6:

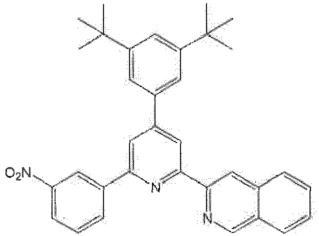

Ligand 6 was synthesized by general procedures in Example 4 with 1.32 g (3.51 mmol) 1-(2-oxo-2-(3'-isoquinolinyl) ethyl) pyridinium iodide, 1.28 g (3.5 mmol) (*E*)-3-(3,5-di-*tert*-butylphenyl)-1-(3-nitrophenyl)prop-2-en-1-one, 5.00g (64.9 mmol) ammonium acetate and 100 mL methanol. Ligand 6 was obtained as yellow solid. Yield: 1.12 g (62 %). ¹H NMR (600 MHz, CDCl₃, 25 °C) δ = 1.44 (s, 18H), 7.59 (d, *J* = 1.5 Hz, 1H), 7.61 (d, *J* = 1.62 Hz, 2H), 7.66 (t, *J* = 7.80 Hz), 7.75 (m, 2H), 7.98 (d, J = 1.2 Hz, 1H), 8.06 (d, *J* = 8.10 Hz, 1H), 8.09 (d, *J* = 8.16 Hz, 1H), 8.34 (d, *J* = 6.12 Hz, 1H), 8.60 (d, *J* = 7.68 Hz, 1H), 8.81 (s, 1H), 9.04 (s, 1H). 9.12 (t, *J* = 1.62 Hz, 1H), 9.38 (s, 1H). FAB-MS (+ve, m/z): 516.4[M⁺].

### Example 8

### Synthetic procedure for Ligand 7:

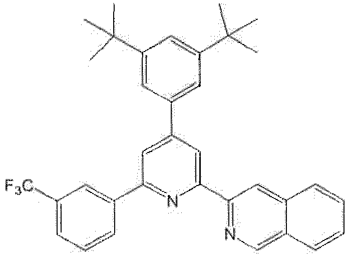

Ligand 7 was synthesized by general procedures in Example 4 with 0.87 g (2.3 mmol) 1-(2-oxo-2-(3'-isoquinolinyl) ethyl)pyridinium iodide, 0.89 g (2.3 mmol) 3',5'-di-tert-butylbenzylidene-2-(1-aceto-3-trifluromethylphenone), 5.00 g (64.9 mmol) ammonium acetate and 100 mL methanol. Ligand 7 was obtained as yellow solid. Yield 1.05 g (85.0 %). ¹H NMR (500 MHz, CDCl₃, 25 °C). δ = 1.47 (s, 18H), 7.60 (s, 1H), 7.63 (s, 2H), 7.68 (t, *J* = 7.8 Hz, 1H), 7.72 (t, *J* = 7.8 Hz, 1H), 7.80 (m, 2H), 8.00 (s, 1H), 8.10 (t, *J* = 8.4 Hz 2H), 8.47 (d, *J* = 7.5 Hz, 1H), 8.55 (s, 1H), 8.80 (s, 1H), 9.00 (s, 1H), 9.35 (s, 1H). ¹³C NMR (500 MHz, CDCl₃, 25 °C): δ = 31.6, 35.1, 118.2, 119.0, 121.7, 123.3, 124.1, 124.2, 125.4, 125.5, 127.6, 127.7, 127.9, 128.9, 129.2, 130.5, 130.6, 130.9, 131.1, 131.4, 131.6, 136.7, 138.5, 140.7, 150.0, 152.1, 151.6. EI-MS (+ve, m/z): 539 [M⁺].

### Example 9

### Synthetic procedure for Ligand 8:

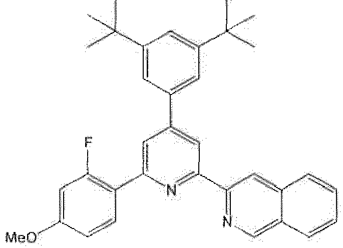

Ligand 8 was synthesized by general procedures in Example 4 with 0.62 g (1.62 mmol) 1-(2-oxo-2-(3'-isoquinolinyl)ethyl)pyridinium iodide, 0.52 g (1.62 mmol)(*E*)-3-(3,5-di-tert-butylphenyl)-(2-fluoro-4methoxyphenyl)prop-2-en-1-one, 5.00g, (64.9 mmol) ammonium acetate and 100 mL methanol. Ligand 8 was obtained as yellow solid. Yield: 0.50 g (60.0 %). ¹H NMR (500 MHz, CDCl₃). δ = 1.42 (s, 18H), 3.90 (s, 3H), 6.76 (d, *J* = 13 Hz, 1H), 6.93 (d, *J* = 6.68 Hz), 7.54 (s, 1H), 7.62 (m, 3H), 7.72 (t, *J* = 7.25 Hz, 1H), 8.00 (m, 3H), 8.27 (t, *J* = 8.9 Hz, 1H), 8.70 (d, *J* = 1.2 Hz, 1H), 8.98 (s, 1H), 9.37 (s, 1H). ¹³C NMR (500 MHz, CDCl₃): δ = 31.7, 35.1, 55.7, 101.9, 102.1, 110.7, 117.9, 120.4, 121.8, 122.2, 123.0, 127.5, 127.8, 128.8, 130.5, 131.9, 132.0, 136.7, 138.6, 150.3, 151.4, 152.0, 153.1, 156.4, 160.6, 161.4, 161.5, 162.6. EI-MS (+ve, m/z): 519.4 [M⁺].

### Example 10

### Synthetic procedure for Ligand 9:

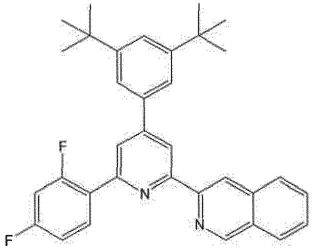

Ligand 9 was synthesized by general procedures in Example 4 with 1.00 g (2.66 mmol) 1-(2-oxo-2-(3'-isoquinolinyl) ethyl) pyridinium iodide, 0.95 g (2.66 mmol) 3-(2,4-di-tert-butylphenyl)-(3,4-difluorophenyl)prop-2-en-1-one, 5.00 g, (64.9 mmol) ammonium acetate and 100 mL methanol. Ligand 9 was obtained as yellow solid. Yield: 1.35 g (70 %).

### Example 11

### Synthetic procedure for Ligand 10:

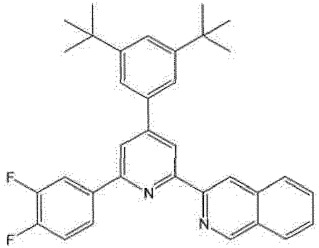

Ligand 10 was synthesized by general procedures in Example 4 with 1.48 g (3.93 mmol) 1-(2-oxo-2-(3'-isoquinolinyl) ethyl) pyridinium iodide, 1.40 g (3.93 mmol) 3-(3,5-di-tert-butylphenyl)-(3,4-difluorophenyl)prop-2-en-1-one, 5.00g, (64.9 mmol) ammonium acetate and 100 mL methanol. Ligand 10 was obtained as yellow solid. Yield: 1.60 g (80.0 %). ¹H NMR (500 MHz, CDCl₃). *δ* = 1.43 (s, 18 H), 7.30-7.36 (m, 1H), 7.56 (s, 1H), 7.59 (s, 2H), 7.63 (t, J = 7.2 Hz, H), 7.77 (t, J = 8.0 Hz, H), 7.86 (s, 1H, H), 7.94-7.97 (m, 1H), 8.03 (d, J = 7.7 Hz, 1H), 8.06 (d, J = 7.8 Hz, 1H), 8.14-8.18 (m, 1H), 8.74 (s, 1H), 9.00 (s, 1H, H), 9.37 (s, 1H, H). 13C NMR (126 MHz, CDCl₃,25°C):*δ*= 31.7, 35.1, 116.3, 116.4, 117.4, 117.5, 118.1, 118.4, 118.8, 121.7, 12 3.0, 123.2, 127.6, 128.9, 130.6, 136.6, 137.0, 138.4, 149.8, 151.7, 151.8, 152.0, 152.2 , 154.9, 156.7. ¹⁹F NMR (376 MHz, CDCl₃, 25 °C): *δ* = -137.4, -137.7. FAB-MS (+ve, m/z): 507 [M⁺].

### Example 12

### Synthetic procedure for Ligand 11:

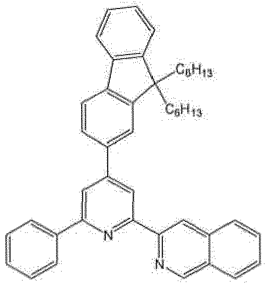

Ligand 11 was synthesized by general procedures in Example 4 with 3.83 g (8.97 mmol) 1-(2-oxo-2-(3'-isoquinolinyl)ethyl)pyridinium iodide, 4.20 g (8.89 mmol) (E)-3-(9,9-dihexyl-9H-fluoren-2-yl)-1-phenylprop-2-en-1-one, 7.1 g (91 mmol) ammonium acetate and 550 mL methanol / dichloromethane (10:1 by volume) mixture . Ligand 11 was obtained as yellow oil. Yield: 4.35 g (82 %). ¹H NMR (400 MHz, CDCl₃): δ 9.39 (s, 1H), 9.07 (s, 1H), 8.82 (s, 1H), 8.28 (d, *J* = 7.3 Hz, 2H), 8.03-8.06 (m, 3H), 7.84 (s, 2H), 7.73-7.79 (m, 3H), 7.64 (t, *J* = 7.0 Hz, 1H), 7.58 (t, *J* = 7.5 Hz, 2H), 7.49 (t, *J* = 7.5 Hz, 2H), 7.35-7.39 (m, 3H), 2.04-2.12 (m, 4H), 1.11-1.23 (m, 12H), 0.73-0.89 (m, 10H). FAB-MS (m/z): 614 [M⁺].

### Example 13

### Synthetic procedure for Ligand 12:

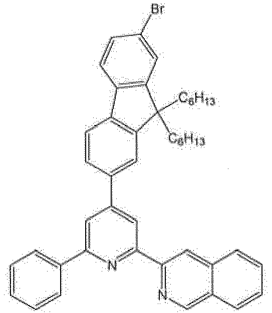

Ligand 12 was synthesized by general procedures in Example 4 with 3.83 g (8.97 mmol) 1-(2-oxo-2-(3'-isoquinolinyl)ethyl)pyridinium iodide, 4.88 g (8.97 mmol) (E)-3-(7-bromo-9,9-dihexyl-9H-fluoren-2-yl)-1-phenylprop-2-en-1-one, 15.4 g, (0.20 mmol) ammonium acetate and 100 mL methanol / chloroform (10:1 by volume) mixture. Ligand 12 was obtained as yellow oil. Yield: 4.52 g (73 %). ¹H NMR (400 MHz, CDCl₃): δ 9.39 (s, 1H), 9.08 (s, 1H), 8.81 (s, 1H), 8.28 (d, *J* = 8.5 Hz, 2H), 8.05 (d, *J* = 8.9 Hz, 2H), 8.01 (s, 1H), 7.74-7.86 (m, 4H), 7.61-7.67 (m, 2H), 7.59 (t, *J* = 7.6 Hz, 2H), 7.49-7.51 (m, 3H), 2.01-2.10 (m, 4H), 1.06-1.18 (m, 12H), 0.65-0.86 (m, 10H). FAB-MS (m/z): 694 [M⁺].

### Example 14

### Synthetic procedure for Ligand 13:

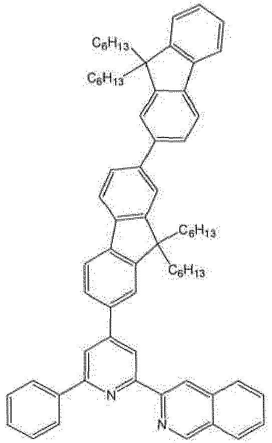

2 M aqueous Na₂CO₃ solution (15 mL) were injected to a degassed toluene solution (150mL) of 1.03 g (1.48 mmol) Ligand 12, 0.17 g (0.154 mmol) tetrakis(triphenylphosphine) palladium(0) and 0.68 g, (1.48 mmol) 9,9-Di-n-hexylfluoren-2-yl-4,4,5,5-tetramethyl-[1,3,2]dioxaborolane by a syringe. The reaction mixture was stirred with 80°C for 12 h. The product was extracted with dichloromethane (3 × 100 mL), washed with water, and dried over MgSO₄. After evaporation of the solvent, the residue was purified by flash chromatography on silica gel using CH₂Cl₂ as eluent to obtain Ligand 13 as pale yellow oil. Yield: 0.89 g, 64 %. ¹H NMR (400 MHz, CDCl₃): δ 9.40 (s, 1H), 9.09 (s, 1H), 8.85 (s, 1H), 8.30 (d, *J* = 7.6 Hz, 2H), 8.04-8.06 (m, 3H), 7.63-7.88 (m, 12H), 7.59 (t, *J* = 7.6 Hz, 2H), 7.50 (t, *J* = 7.6 Hz, 1H), 7.30-7.38 (m, 3H), 2.12-2.17 (m, 4H), 2.02-2.07 (m, 4H), 1.02-1.18 (m, 24H),0.72-0.83 (m, 20H). FAB-MS (m/z): 947 [M⁺].

### Example 15

### General synthetic procedure for complexes 1 - 14.

A mixture of K₂PtCl₄ and ligands 1 - 14 in glacial acetic acid (100 ml) was refluxed for 48 hours to give complexes 1 to 14 as a yellow suspension. The yellow solid was filtered, washed with water and acetone and recrystallized in DMF.

### Example 16

### Synthetic procedure for complex 1:

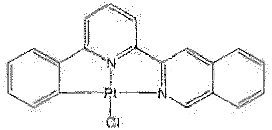

Complex 1 was synthesized by general procedures in Example 15 with 0.42 g (1.01 mmol) K₂PtCl₄, 0.23g (0.82mmol) Ligand 1 and 100 ml glacial acetic acid. Complex 1 was obtained as yellow crystalline solid. Yield: 0.34g (80.0 %). ¹H NMR (400 MHz, DMF, 25 °C): δ = 7.12 (t, *J* = 6.9 Hz, 1H), 7.20 (t, *J* = 6.9 Hz, 1H), 7.68 (d, *J* = 6.6 Hz, 1H), 7.73 (d, *J* = 7.5 Hz, 1H), 7.97 (m, 1H), 8.11 (t, *J* = 7.3 Hz 1H), 8.22 (m, 4H), 8.54 (d, *J* = 7.5 Hz, 1H), 9.15 (s, 1H), 9.75 (s, 1H). ¹³C NMR (500 MHz, CDCl₃, 25 °C): δ = 119.4, 123.1, 124.4, 125.2, 128.8, 130.0, 130.3, 130.7, 130.9, 131.4, 134.5, 135.3, 136.7, 140.1, 143.7, 148.0, 151.0, 152.7, 155.6, 163.2. FAB-MS (+ve, m/z): 512 [M⁺].

### Example 17

### Synthetic procedure for complex 2:

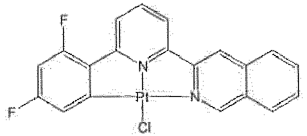

Complex 2 was synthesized by general procedures in Example 15 with 0.49 g (1.17 mmol) K₂PtCl₄, 0.31g (0.98mmol) Ligand 2 and 100 ml glacial acetic acid. Complex 2 was obtained as yellow crystalline solid. Yield: 0.43g (80.0 %). ¹H NMR (500 MHz, DMF) δ = 7..37 (t, *J* = 8.44 Hz, 1H), 7.44 (t, *J* = 9.98 Hz, 1H), 8.03 (d, *J* = 7.75 Hz, 1H), 8.11 (m, 1H), 8.32 (t, *J* = 7.6 Hz), 8.44 (d, *J* = 8.15 Hz, 1H), 8.67 (t, *J* = 7.85 Hz, 1H), 8.73 (d, *J* = 7.95 Hz, 1H), 8.92 (d, *J* = 8.13 Hz), 9.44 (s, 1H), 10.39 (s, 1H). ¹³C NMR (500 MHz, CDCl₃): δ = 103.9, 104.0, 111.5, 121.8, 123.4, 128.4, 129.6, 130.2, 131.5, 134.0, 134.6, 135.9, 140.3, 151.2, 153.2, 157.4, 159.9, 162.7, 163.0, 164.1.

### Example 18

### Synthetic procedure for complex 3:

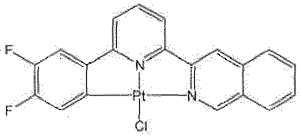

Complex 3 was synthesized by general procedures in Example 15 with 0.78 g (1.88 mmol) K₂PtCl₄, 0.50g (1.57mmol) Ligand 3 and 100 ml glacial acetic acid. Complex 3 was obtained as yellowish green crystalline solid. Yield: 0.69g (80.0 %). FAB-MS (+ve, m/z): 512 [M-Cl⁺].

### Example 19

### Synthetic procedure for complex 4:

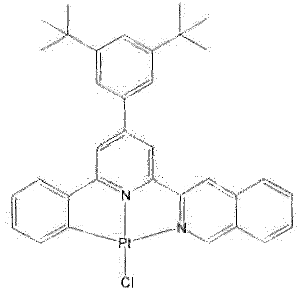

Complex 4 was synthesized by general procedures in Example 15 with 0.31 g (0.75 mmol) K₂PtCl₄, 0.29 g (0.62 mmol) Ligand 4 and 100 ml glacial acetic acid. Complex 4 was obtained as yellow crystalline solid. Yield: 0.39g (90.0 %). ¹H NMR (400 MHz, DMF, 25 °C): δ =1.47 (s, 18H), 7.10 (m, 2H), 7.67 (d, *J* = 6.6 Hz, 1H), 7.77 (s, 1H), 7.79 (d, *J* = 6.7 Hz, 1H), 7.92 (t, *J* = 7.3 Hz, 1H), 7.97 (s, 2H), 8.08 (t, *J* = 7.6 Hz, 1H), 8.12 (d, *J* = 4.2 Hz, 2H), 8.39 (d, *J* = 8.1 Hz, 1H), 8.54 (s, 1H), 9.27 (s, 1H), 9.65 (s, 1H). ¹³C NMR (500 MHz, CDCl₃, 25 °C): δ = 31.5, 35.7, 117.4, 117.8, 122.7, 123.3, 123.4, 124.2, 124.7, 125.5, 128.7, 129.9, 130.2, 130.4, 131.2, 134.3, 135.2, 136.7, 137.9, 143.7, 148.2, 151.2, 152.5, 152.9, 155.5, 162.3. FAB-MS (+ve, m/z): 700 [M⁺].

### Example 20

### Synthetic procedure for complex 5:

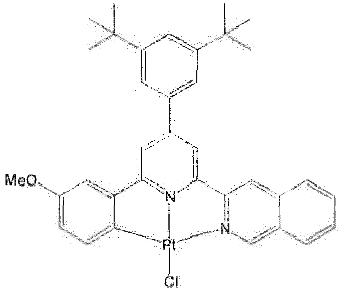

Complex 5 was synthesized by general procedures in Example 15 with 0.37 g (0.90 mmol) K₂PtCl₄, 0.28 g (0.54 mmol) ligand 5 and 100 ml glacial acetic acid. Complex 5 was obtained as yellow crystalline solid. Yield: 0.28 g (70.0 %). ¹H NMR (500 MHz, DMF, 25°C): δ = 1.47 (s, 18H), 3.93 (s, 3H), 6.90 (d, *J* = 7.7 Hz, 1H), 7.54 (s, 1H), 7.60 (d, *J* = 8.3 Hz, 1H), 7.73 (s, 1H), 7.95 (m, 3H), 8.12 (t, *J* = 7.5 Hz, 1H), 8.17 (d, *J* = 8.1 Hz, 1H), 8.33 (s, 1H), 8.52 (d, *J* = 8.1 Hz, 1H), 8.58 (s, 1H), 9.32 (s, 1H), 9.75 (s, 1H). ¹³C NMR (500 MHz, DMF, 25°C): δ = 31.6, 35.7, 111.6, 116.7, 117.7, 118.0, 122.8, 123.4, 124.7, 128.7, 129.9, 130.3, 131.3, 133.5, 134.3, 135.8, 136.6, 138.0, 148.7, 151.2, 152.3, 152.4, 153.1, 155.6, 158.1, 162.5 FAB-MS (+ve, m/z): 730 [M⁺].

### Example 21

### Synthetic procedure for complex 6:

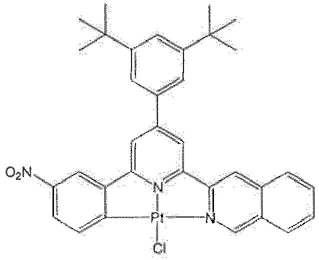

Complex 6 was synthesized by general procedures in Example 15 with 0.17 g (0.45 mmol) K₂PtCl₄, 0.18 g (0.35 mmol) ligand 6 and 100 ml glacial acetic acid. Complex 6 was isolated as a yellow crystalline solid. Yield: 0.23 g (90.0 %). ¹H NMR (500 MHz, CD₂Cl₂, 25 °C): δ = 1.50 (s, 18H), 7.12 (s, 1H), 2.93 (m, 2H,), 7.44 (d, *J* = 7.55 Hz, 1H), 7.55 (t, *J* = 6.85 Hz, 1H), 7.66 (s, 2H), 7.70 (m, 3H), 7.76 (t, *J* = 7.15 Hz, 1H), 7.81 (d, *J* = 8.05 Hz, 1H), 8.13 (s, 1H), 8.91 (s, 1H). FAB-MS (+ve, m/z): 745.2[M⁺].

### Example 22

### Synthetic procedure for complex 7:

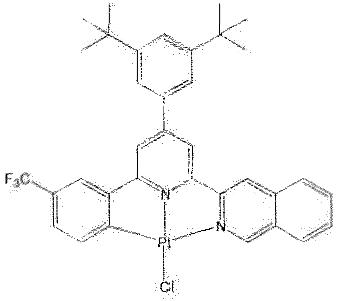

Complex 7 was synthesized by general procedures in Example 15 with 0.19 g (0.46 mmol) K₂PtCl₄, 0.20 g (0.38 mmol) ligand 7 and 100 ml glacial acetic acid. Complex 5 was obtained as yellow crystalline solid. Yield: 0.20g (70.0%). ¹H NMR (500 MHz, DMF, 25 °C): δ = 1.47 (s, 18H), 7.37 (d, *J* = 7.7 Hz, 1H), 7.75 (s, 1H), 7.80 (d, *J* = 7.8 Hz, 1H), 7.90 (t, *J* = 7.1 Hz, 1H), 7.98 (s, 2H), 8.10 (m, 2H), 8.30 (d, *J* = 8.0 Hz, 1H), 8.40 (s, 2H), 8.60 (s, 1H), 9.25 (s, 1H), 9.50 (s, 1H). ¹³C NMR (500 MHz. DMF, 25 °C): δ = 31.5, 35.7, 117.6, 118.4, 118.7, 121.4, 121.7, 121.9 , 122.1, 122.9, 123.3, 123.7, 124.9, 125.6, 126.4, 127.1, 128.8, 130.0, 131.4, 134.1, 134.5, 135.3, 136.7, 137.7, 142.3, 146.2, 146.9, 162.7. FAB-MS (+ve, m/z): 768 [M⁺].

### Example 23

### Synthetic procedure for complex 8:

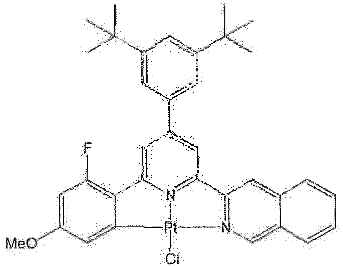

Complex 8 was synthesized by general procedures in Example 15 with 0.17 g (0.45 mmol) K₂PtCl₄, 0.44 g (0.86 mmol) ligand 8 and 100 ml glacial acetic acid. Complex 8 was obtained as orange crystalline solid. Yield: 0.52 g (80.0 %). ¹H NMR (500 MHz, DMF, 25 °C): *δ* = 1.64 (s, 18H), 3.73 (s, 3H), 6.59 (d, *J* = 14.1 Hz, 1H), 7.00 (d, *J* = 2.4 Hz, 1H), 7.80 (s, 1H), 7.90 (t, *J* = 1.6 Hz 1H), 8.00 (t, *J* = 7.8 Hz, 1H), 8.04 (d, *J* = 1.7 Hz, 2H), 8.21 (m, 1H), 8.27 (d, *J* = 4.05 Hz, 1H), 8.29 (d, *J* = 4.3 Hz, 1H), 8.49 (s, 1H), 9.28 (s, 1H), 9.59 (s, 1H). ¹³C NMR (126 MHz, DMF, 25 °C): *δ*= 30.0, 35.2, 97.4, 115.6, 116.7, 119.2, 119.3, 122.2, 123.0, 124.2, 126.7, 128.3, 129.2, 129.5, 130.7, 133.8, 136.2, 137.9, 145.9, 151.0, 152.0, 152.1, 155, 160.1, 162.1, 162.4, 162.6, 163.2, 163.8. FAB-MS (+ve, m/z): 748.2[M⁺].

### Example 24

### Synthetic procedure for complex 9:

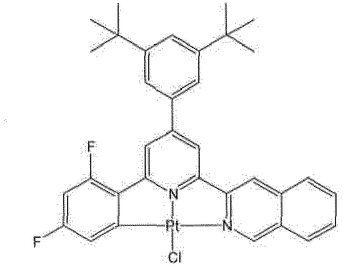

Complex 9 was synthesized by general procedures in Example 15 with 0.49 g (1.18 mmol) K₂PtCl₄, 0.50 g (0.99 mmol) ligand 9 and 100 ml glacial acetic acid. Complex 8 was obtained as orange crystalline solid. Yield: 0.58 g (80.0 %). ¹H NMR (500 MHz, CD₂Cl₂, 25 °C): *δ* = 1.48 (s, 18H), 6.39-6.44 (m, 1H), 6.97 (d, *J* = 8.5 Hz, 1H), 7.63-7.67 (m, 5H), 7.73 (d, *J* = 8.2 Hz), 7.80-7.83 (m, 2H), 7.91 (d, *J* = 8.2 Hz, H), 8.33 (s, 1H), 9.24 (s, 1H). ¹³C NMR (126 MHz, CD₂Cl₂, 25 °C): *δ* = 31.4, 35.2, 99.0, 99.2, 116.7, 116.8, 120.1, 120.3, 121.8, 121.9, 124.3, 127.9, 128.7, 129.2, 130.2, 133.2, 135.7, 137.4, 150.6, 152.1, 152.2, 152.6, 154.4. ¹⁹F NMR (400 MHz, CD₂Cl₂, 25 °C): *δ*= -105.9, -111.3.

### Example 25

### Synthetic procedure for complex 10:

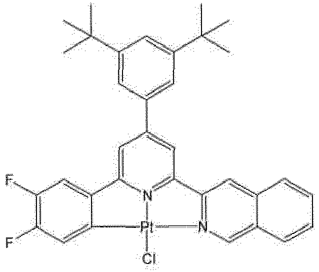

Complex 10 was synthesized by general procedures in Example 15 with 0.93 g (2.37 mmol) K₂PtCl₄, 1.00 g (1.97 mmol) ligand 10 and 100 ml glacial acetic acid. Complex 10 was obtained as yellow solid. Yield: 0.87 g (60.0 %). ¹H NMR (500 MHz, CD₂Cl₂, 25 °C): *δ* = 1.49 (s, 18H), 6.97-7.01 (m, 1H), 7.06-7.10 (m, 2H), 7.60-7.68 (m, 5H), 7.74 (s, 1H), 7.83 (t, *J* = 8.1 Hz, H), 7.92 (d, *J* = 8.1 Hz, H), 8.25 (s, 1H), 9.17 (s, 1H). ¹³C NMR (126 Hz, CD₂Cl₂, 25 °C): *δ* = 31.4, 35.2, 112.3, 112.4, 116.5, 117.1, 121.7, 121.9, 122.0, 124.4, 127.8, 127.9, 128.6, 129.1, 130.2, 133.2, 135.5, 137.2, 139.1, 150.4, 152.0, 152.3, 152.4, 154.6, 163.0. ¹⁹F NMR (400 MHz, CDCl₃, 25 °C): *δ* = -134.3, -146.0. FAB-MS (+ve, m/z): 700 [M-Cl]⁺.

### Example 26

### Synthetic procedure for complex 11:

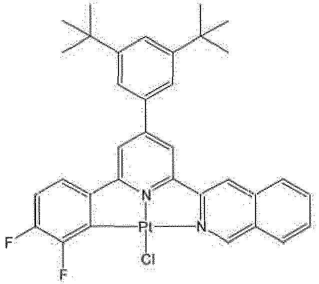

Complex 11 was synthesized by general procedures in Example 15 with 0.93 g (2.37 mmol) K₂PtCl₄, 1.00 g (1.97 mmol) ligand 10 and 100 ml glacial acetic acid. Complex 11 was obtained as yellow solid. Yield: 0.44 g (30.0 %). ¹H NMR (500 MHz, CD₂Cl₂, 25 °C): *δ* = 1.54 (s, 18H), 6.80 (m, 1H), 7.18 (m, 1H), 7.39 (s, 1H), 7.65 (s, 2H), 7.68 (s, 1H), 7.69 (t, *J* = 7.2 Hz, 1H), 7.82 (s, 1H), 7.87 (m, 2H), 7.98 (d, *J* = 8.1 Hz, 1H), 8.36 (s, 1H), 9.59 (s, 1H). ¹³C NMR (126 MHz, CD₂Cl₂, 25 °C): *δ* = 31.4, 35.2, 112.1, 112.3, 116.9, 117.3, 120.8, 121.6, 121.7, 124.5, 127.9, 129.0, 129.1, 130.4, 133.6, 135.7, 137.2, 150.7, 151.3, 152.3, 152.7, 154.7, 163.9. ¹⁹F NMR (376 MHz, CDCl₃, 25 °C): -121.9, -132.5. FAB-MS (+ve, m/z): 700 [M-Cl]⁺.

### Example 27

### Synthetic procedure for complex 12:

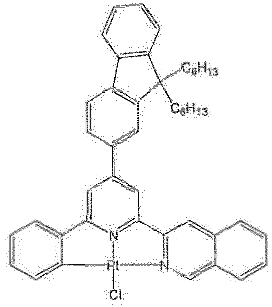

Complex 12 was synthesized by general procedures in Example 15 with 0.71 g (1.71 mmol) K₂PtCl₄, 1.05 g (1.71 mmol) ligand 11 and 50 ml glacial acetic acid. Complex 12 was obtained as yellow solid. Yield: 1.3 g (86 %). ¹H NMR (400 MHz, CD₂Cl₂): δ 9.70 (s, 1H), 8.51 (s, 1H), 8.11 (d, *J* = 8.0 Hz, 1H), 8.04 (d, *J* = 8.2 Hz, 1H), 7.98 (s, 1H), 7.92-7.96 (m, 2H), 7.785-7.85 (m, 3H), 7.69 (t, *J* = 6.4 Hz, 1H), 7.50 (d, *J* = 7.5 Hz, 1H), 7.39-7.45 (m, 3H), 7.18 (t, *J* = 6.4 Hz, 1H), 7.13 (t, *J* = 7.5 Hz, 1H), 2.08-2.16 (m, 4H), 1.08-1.39 (m, 12H), 0.69-0.89 (m, 10H). FAB-MS (m/z): 844 [M⁺].

### Example 28

### Synthetic procedure for complex 13:

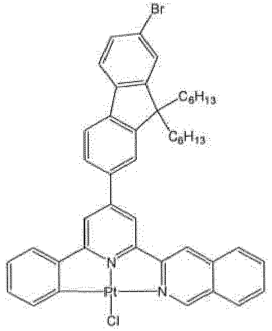

Complex 13 was synthesized by general procedures in Example 15 with 0.71 g (1.71 mmol) K₂PtCl₄, 1.19 g (1.71 mmol) ligand 12 and 50 ml glacial acetic acid. Complex 13 was obtained as yellow solid. Yield: 1.3 g (86 %). ¹H NMR (400 MHz, CD₂Cl₂): δ 9.33 (s, 1H), 8.39 (s, 1H), 7.86-7.93 (m, 5H), 7.82 (t, *J* = 7.5 Hz, 1H), 7.72-7.76 (m, 2H), 7.55-7.63 (m, 3H), 7.47 (d, *J* = 7.4 Hz, 1H), 7.30 (s, 1H), 7.23 (d, *J* = 7.0 Hz, 1H), 6.99 (t, *J* = 7.2 Hz, 1H), 6.94 (t, *J* = 7.2 Hz, 1H), 2.19-2.25 (m, 2H), 2.02-2.13 (m, 2H), 2.02-2.09 (m, 4H), 1.11-1.22 (m, 12H), 0.72-0.81 (m, 10H). FAB-MS (m/z): 923 [M⁺].

### Example 29

### Synthetic procedure for complex 14:

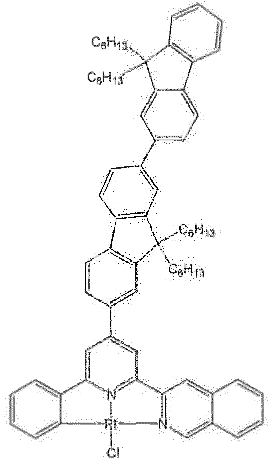

Complex 14 was synthesized by general procedures in Example 15 with 0.71 g (1.71 mmol) K₂PtCl₄, 1.62 g (1.71 mmol) ligand 13 and 50 ml glacial acetic acid. Complex 9 was obtained as orange solid. Yield: 1.3 g, 86 %. ¹H NMR (400 MHz, CD₂Cl₂): δ 9.56 (s, 1H), 8.48 (s, 1H), 7.83-8.02 (m, 8H), 7.64-7.77 (m, 6H), 7.60-7.63 (m, 2H), 7.57 (s, 1H), 7.49 (t, *J* = 7.3 Hz, 1H), 7.42 (m, 1H), 7.37 (t, *J* = 7.5 Hz, 1H), 7.08 (m, 2H), 2.23-2.33 (m, 2H), 2.06-2.15 (m, 2H), 1.01-1.38 (m, 12H), 0.76-0.87 (m, 10H). FAB-MS (m/z): 1177 [M⁺].

### Example 30

### Synthetic procedure for complex 15:

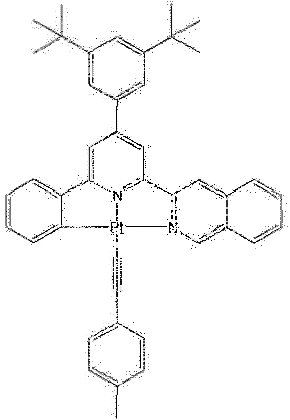

Complex 4 (0.17 g, 0.24 mmol), 1-ethyl-4-methylbenzene (0.18 ml, 1.43 mmol) and triethylamine (1 ml, 6.68 mmol) were dissolved in a solution of acetonitrile: dichloromethane (3:1) (30 ml). Cul (5 mg) was added to the reaction mixture as a catalyst. The yellow mixture was stirred under nitrogen for 48 hr at room temperature. The orange solid was then filtered and washed with cold acetonitrile and diethyl ether. Then the solid was dry to give orange complex 15. Yield: 0.16 g (84%). FAB-MS (+ve, m/z): 779 [M⁺].

### Example 30a

### Synthesis for complex 16:

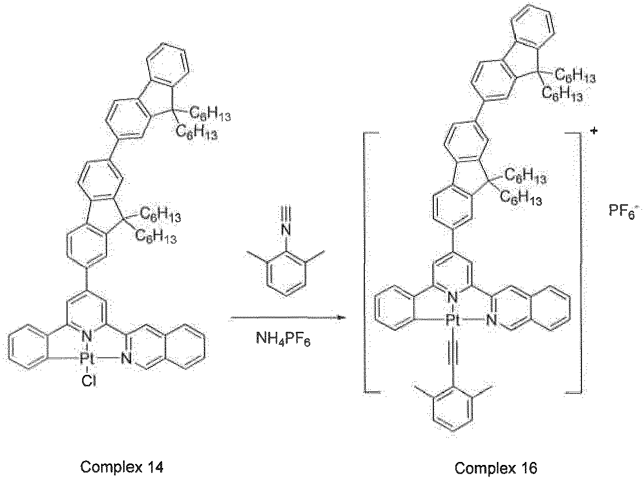

A mixture of complex **14** (100 mg, 0.085 mmol), 2,6-dimethylphenyl isocyanide (12 mg, 0.086 mmol) and excess NH₄PF₆ (500 mg, 3.06 mmol) in CH₂Cl₂/CH₃CN solution (*v*:*v*, 1:1) was stirred for 12 hours to give complex **16** as yellow solution. Solvent was removed under reduced pressure to yield orange solids. The resultant orange solids were collected, washed with copious of H₂O, CH₃CN and Et₂O then dried. Pure product (108 mg, yield 90%) was isolated as orange crysals by layering of n-hexane onto concentrated CH₂Cl₂ solution. FAB-MS (+ve m/z): 1270 [M-PF₆]⁺. ¹H NMR (CD₂Cl₂): δ 0.70-0.72 (m, 4H, -CH₂-), 0.76-0.79 (m, 16H, -CH₂- and -CH₃), 1.08-1.26 (m, 24H, -CH₂-), 2.06-2.11 (m, 4H, -CH₂-), 2.22-2.42 (m, 4H, -CH₂-), 2.62 (s,6H), 7.21 (t, *J* = 8.9 Hz, 1H), 7.27-7.42 (m, 7H), 7.44-7.51 (m, 1H), 7.68-7.71 (m, 3H), 7.45-7.77 (m, 3H), 7.82-7.85 (m, 2H), 7.89-7.93 (m, 3H), 7.95-8.03 (m, 3H), 8.15 (d, *J* = 8.3 Hz, 1H), 8.20 (d, *J* = 8.2 Hz, 1H), 8.30 (s, 1H), 9.80 (s, 1H), 9.48 (s, 1H).

### Example 31

Example 31 illustrates general procedures for preparing OLEDs in present invention. The OLEDs were prepared on patterned indium-tin-oxide (ITO) glass with a sheet resistance of 20 Ω. Thermal vacuum deposition of the materials was carried out sequentially under a vacuum of 133,322 x 10⁻⁴ Pa in a thin film deposition system (MBraun three-glove box system integrated with an Edwards Auto 306 deposition system). The devices were encapsulated using anodized aluminum caps and their performance was examined using Photoresearch PR-650. The current-voltage characteristics were studied using a Keithley 2400 sourcemeter. The OLEDs employing Complexes 1 - 6 and 14 have the following configuration: ITO (indium tin oxide) / NPB (4,4'-*bis*[*N*-(1-naphthyl)-*N*-phenylamino]biphenyl, 40 nm) / CBP (4,4'-*N*,*N*'-dicarbazolebiphenyl) : Complexes 1 - 6 and 14, X %, 30 nm) / BCP (bathocuprine, 15 nm) / Alq₃ (*tris*(8-quinolinolato)aluminum, 30 nm) / LiF (0.5 nm) / Al (100 nm).

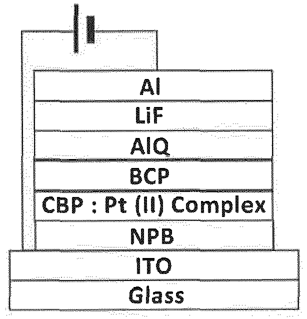

### Example 32

Example 32 illustrates the devices performance of OLED devices fabricated by the method stated in Example 31 using complexes 1 - 6 and 14 as emitting materials.

| Device | Complex | Conc. ₒₚₜᵢₘᵤₘ (X)/ % | Bₘₐₓ/cdm⁻² | CIE | ηₘₐₓ/cdA⁻¹ | ηₘₐₓ/luW⁻¹ | EQEₘₐₓ/% |
|---|---|---|---|---|---|---|---|
| A | 1 | 2 | 39632 | 0.39,0.57 | 13.2 | 6.9 | 3.7 |
| B | 2 | 5 | 30048 | 0.38,0.59 | 15.7 | 8.2 | 5.0 |
| C | 3 | 2 | 52728 | 0.37,0.59 | 16.3 | 7.0 | 4.8 |
| D | 4 | 4 | 50848 | 0.40,0.58 | 28.6 | 12.9 | 9.3 |
| E | 5 | 4 | 30024 | 0.41,0.56 | 8.0 | 3.6 | 2.4 |
| F | 6 | 2 | 26296 | 0.37,0.61 | 21.6 | 8.5 | 6.5 |
| G | 14 | 8 | 29016 | 0.44, 0.54 | 13.9 | 5.5 | 4.2 |

### Example 33

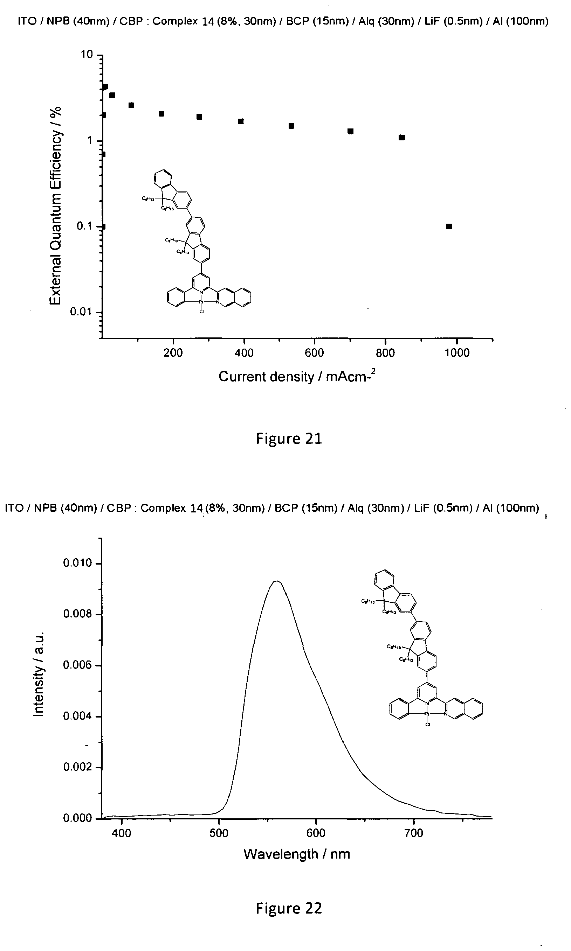

Example 33 illustrates general procedures for preparing OLEDs in present invention. The OLEDs were prepared on patterned indium-tin-oxide (ITO) glass with a sheet resistance of 20 Ω. Thermal vacuum deposition of the materials was carried out sequentially under a vacuum of 133,322 x 10⁻⁴ Pa in a thin film deposition system (MBraun three-glove box system integrated with an Edwards Auto 306 deposition system). The devices were encapsulated using anodized aluminum caps and their performance was examined using Photoresearch PR-650. The current-voltage characteristics were studied using a Keithley 2400 sourcemeter. The OLEDs employing Complexe 13 have the following configuration: ITO (indium tin oxide) / NPB (4,4'-*bis*[*N*-(1-naphthyl)-*N*-phenylamino]biphenyl, 40 nm) / CBP (4,4'-*N*,*N*'-dicarbazolebiphenyl) : Complexe 13, 3.5 %, 20 nm) / BCP (bathocuprine, 40 nm) / LiF (0.5 nm) / Al (100 nm) (device H). Figure 21 shows J-V-B curves of device H. The threshold voltage of is <54 V for 1 cd/m². Device H shows maximum luminance of 8270 cd m⁻² at 14 V.

### Example 34

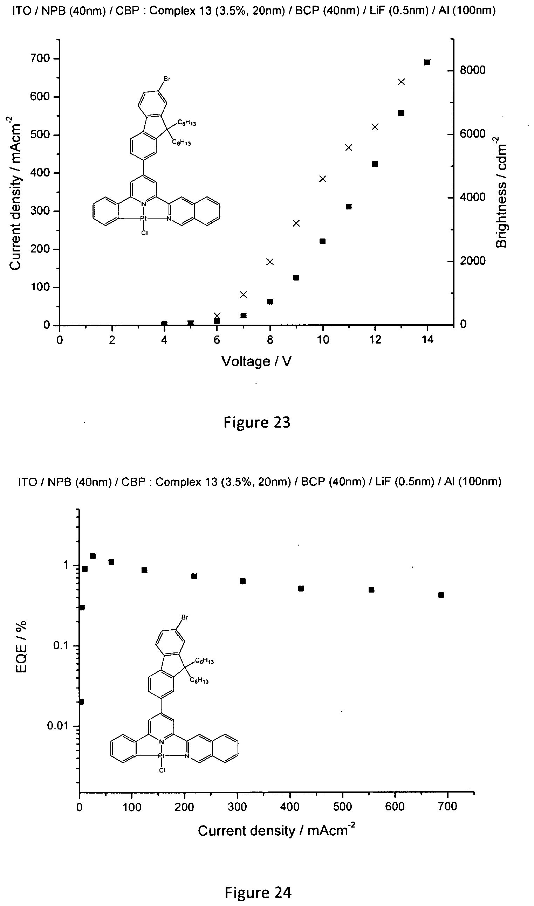

Example 34 illustrates general procedures for preparing a WOLED (device I) in present invention. The WOLED was prepared on patterned indium-tin-oxide (ITO) glass with a sheet resistance of 20 Ω. Thermal vacuum deposition of the materials was carried out sequentially under a vacuum of 133,322 x 10⁻⁴ Pa in a thin film deposition system (MBraun three-glove box system integrated with an Edwards Auto 306 deposition system). The devices were encapsulated using anodized aluminum caps and their performance was examined using Photoresearch PR-650. The current-voltage characteristics were studied using a Keithley 2400 sourcemeter. The WOLEDs employing Complex have the following configuration: ITO (indium tin oxide) / NPB (4,4'-*bis*[*N*-(1-naphthyl)-*N*-phenylamino]biphenyl, 40 nm) / CBP (4,4'-*N*,*N*'-dicarbazolebiphenyl) : Complexe 12, 4.2 %, 20 nm) / NPB, (2 nm)/ 9,10-bis-(2-naphthyl)-anthrene (DNA, 1nm)/ BCP (bathocuprine, 40 nm) / LiF (0.5 nm) / Al (100 nm) (device I). Figure 24 shows J-V-B curves of device I. The threshold voltage of is <5 V for 1 cd/m². Device H shows maximum luminance of 7996 cd m⁻² at 13 V and CIE of (0.32, 0.31).

## Claims

1. An organometallic complex having a chemical structure of structure I: 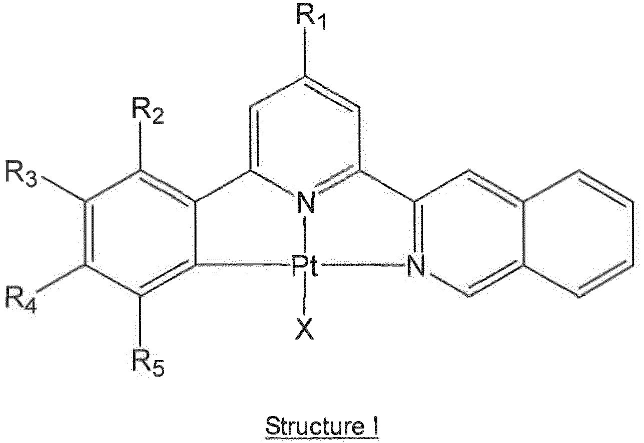 wherein R₁-R₅ are independently hydrogen, halogen, hydroxyl, an unsubstituted alkyl, a substituted alkyl having substituents which are halogen, alkyl radicals, aryl radicals, heteroaryl radicals, alkenyl radicals, groups which display a +I and/or +M effect or groups which display a -I and/or -M effect, cycloalkyl, an unsubstituted aryl, a substituted aryl having substituents which are halogen, alkyl radicals, aryl radicals, heteroaryl radicals, alkenyl radicals, groups which display a +I and/or +M effect or groups which display a -I and/or -M effect, acyl, alkoxy, acyloxy, amino, nitro, acylamino, aralkyl, cyano, carboxyl, thio, styryl, aminocarbonyl, carbamoyl, aryloxycarbonyl, phenoxycarbonyl, or an alkoxycarbonyl group; X is halogen, 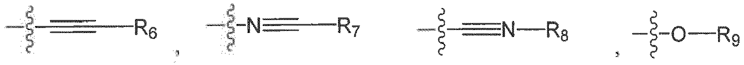 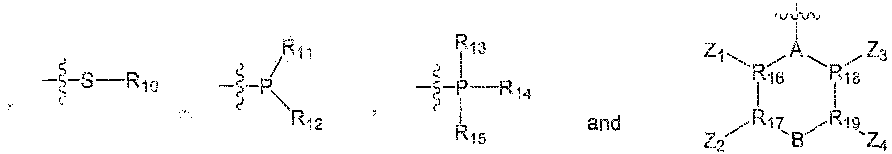 wherein A is carbon, nitrogen, oxygen, silicon, phosphorus, sulphur, arsenic and selenium; B is a chemical bonding connecting R₁₇ and R₁₉, 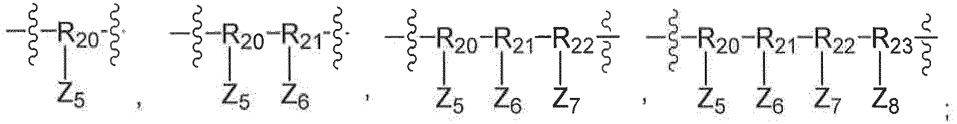 R₆-R₁₅ are independently hydrogen, alkyl, substituted alkyl having substituents which are halogen, alkyl radicals, aryl radicals, heteroaryl radicals, alkenyl radicals, groups which display a +I and/or +M effect or groups which display a -I and/or -M effect, cycloalkyl, aryl, and substituted aryl group having substituents which are halogen, alkyl radicals, aryl radicals, heteroaryl radicals, alkenyl radicals, groups which display a +I and/or +M effect or groups which display a -I and/or -M effect; R₁₆ - R₂₃ are independently carbon, nitrogen, oxygen, silicon, phosphorus, sulphur, arsenic and selenium; Z₁ - Z₈ are independently hydrogen, alkyl, substituted alkyl having substituents which are halogen, alkyl radicals, aryl radicals, heteroaryl radicals, alkenyl radicals, groups which display a +I and/or +M effect or groups which display a -I and/or -M effect, cycloalkyl, aryl, substituted aryl group having substituents which are halogen, alkyl radicals, aryl radicals, heteroaryl radicals, alkenyl radicals, groups which display a +I and/or +M effect or groups which display a -I and/or -M effect, and Z₁ - Z₈ can form 5 - 7 member ring(s) with neighboring groups.

2. The organometallic complex of claim 1 wherein Structure I is one of the following compounds:
| | |
|---|---|
| 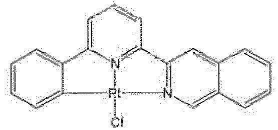 | 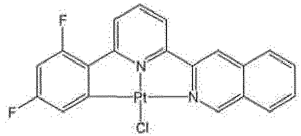 |
| Complex 1 | Complex 2 |
| 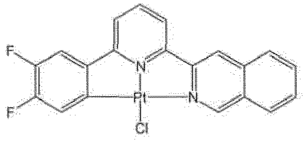 | 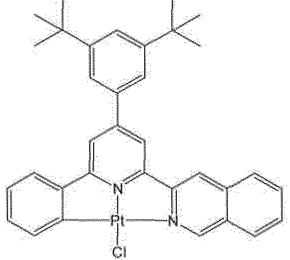 |
| Complex 3 | Complex 4 |
| 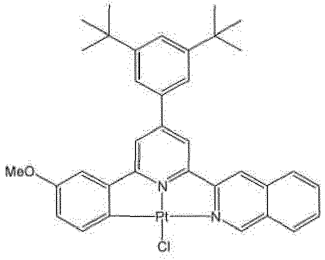 | 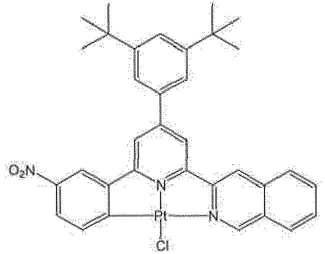 |
| Complex 5 | Complex 6 |
| 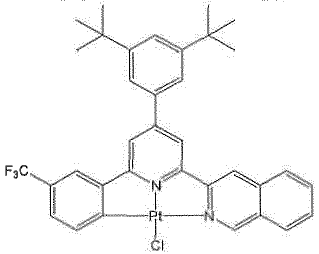 | 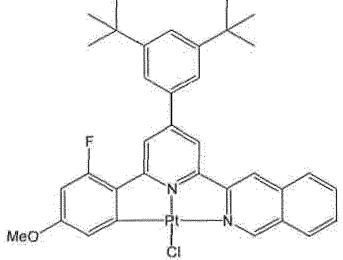 |
| Complex 7 | Complex 8 |
| 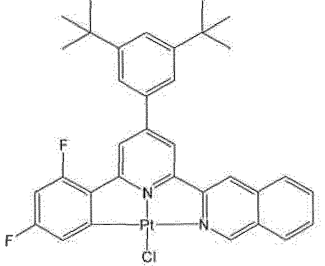 | 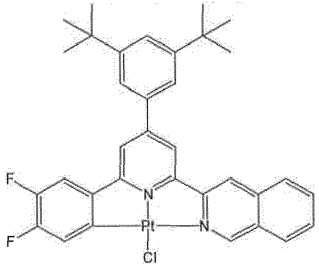 |
| Complex 9 | Complex 10 |
| 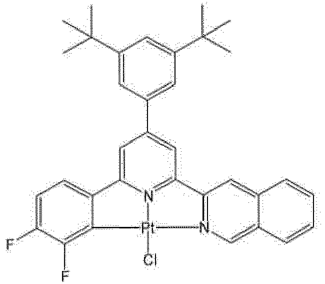 | 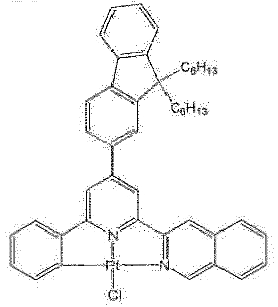 |
| Complex 11 | Complex 12 |
| 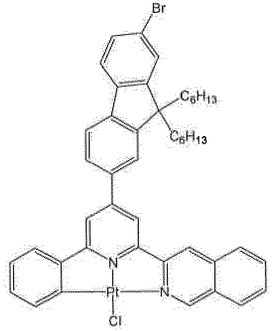 | 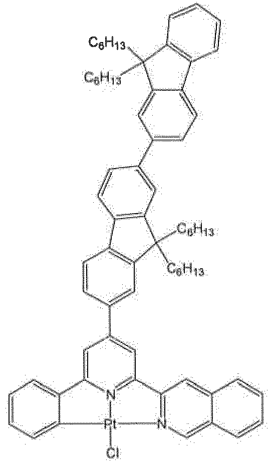 |
| Complex 13 | Complex 14 |
| 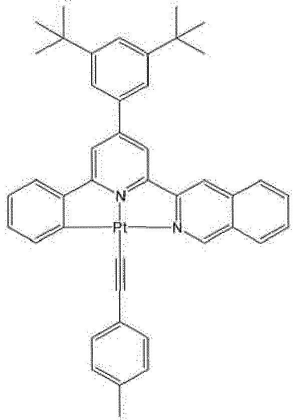 | 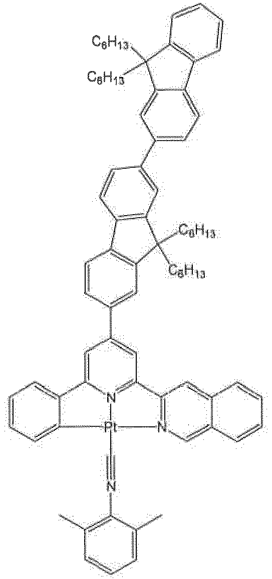 |
| Complex 15 | Complex 16 |

3. An organic light-emitting device including a light-emitting material containing one or more of the organometallic complexes set forth in claim 1 .

4. The organic light-emitting device as set forth in claim 3, wherein the complex has one of the following structures:
| | |
|---|---|
| 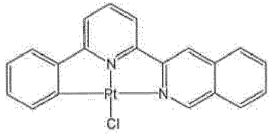 | 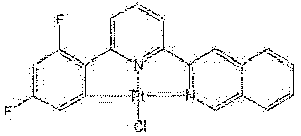 |
| Complex 1 | Complex 2 |
| 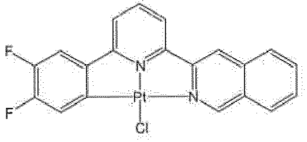 | 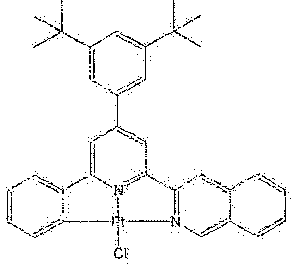 |
| Complex 3 | Complex 4 |
| 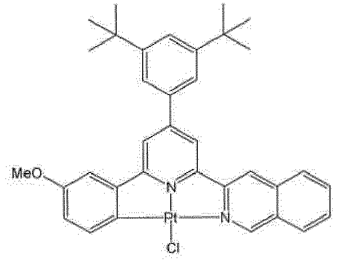 | 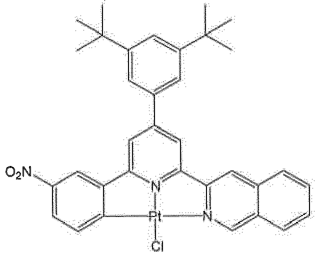 |
| Complex 5 | Complex 6 |
| 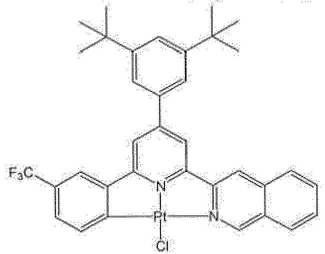 | 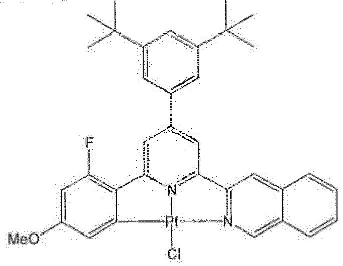 |
| Complex 7 | Complex 8 |
| 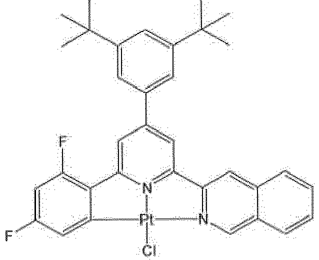 | 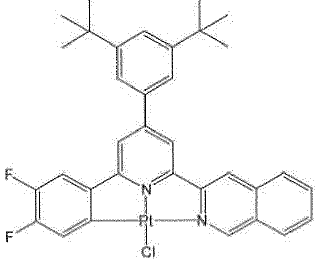 |
| Complex 9 | Complex 10 |
| 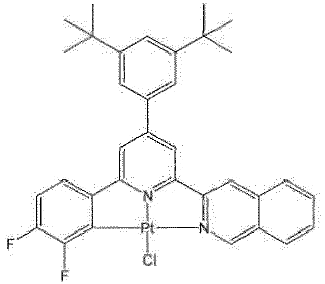 | 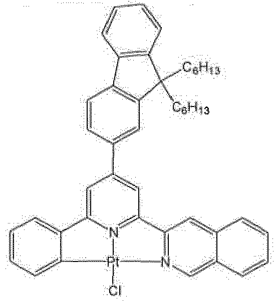 |
| Complex 11 | Complex 12 |
| 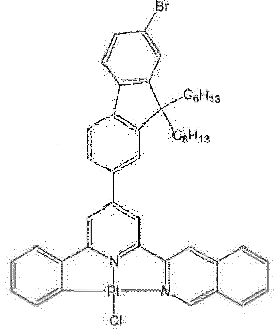 | 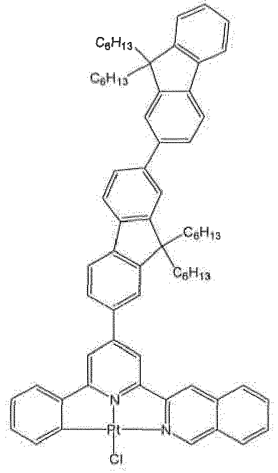 |
| Complex 13 | Complex 14 |
| 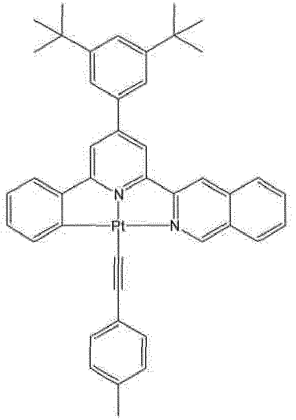 | 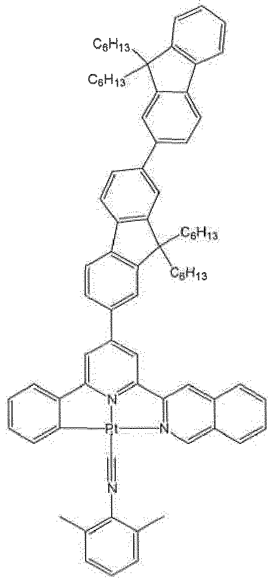 |
| Complex 15 | Complex 16 |

5. An organic light-emitting device as set forth in in claim 3 or 4, wherein the organometallic complex is applied as a layer in the device by thermal deposition.

6. An organic light-emitting device as set forth in in any one of claims 3 to 5, wherein the organometallic complex is applied as a layer in the device by spin coating.

7. An organic light-emitting device as set forth in any one of claims 3 to 6, wherein the organometallic complex is applied as a layer in the device by ink-jet printing.

8. An organic light-emitting device as set forth in any one of claims 3 to 7, wherein the device emits a single color when an electric current is applied to a layer.

9. An organic light-emitting device as set forth in any one of claims 3 to 8, wherein the device emits white light when an electric current is applied to a layer containing the one or more organometallic complexes as set forth in claim 1 or 2 and when an electric current is applied to one or more emission components from other emitting materials.

10. An organic light-emitting device comprising:
a transparent substrate;
a transparent electrode;
a hole transporting layer;
an emissive layer comprising a host material doped with least one of the organometallic complex as set forth in claim 1 or 2;
a hole blocking layer;
an electron transporting layer;
a charge injection layer; and
an electrode.

11. An organic light-emitting device comprising:
a transparent substrate;
a transparent electrode;
a hole transporting layer;
an emissive layer comprising a host material doped with at least one of the organometallic complexes as set forth in claim 1 or 2;
a hole transporting layer;
an emissive layer comprising a blue to sky blue emitting material;
a hole blocking layer;
a charge injection layer; and
an electrode.

12. A method of making an organometallic complex according to claim 1 comprising:
reacting the corresponding ligand identified as Structure II below: 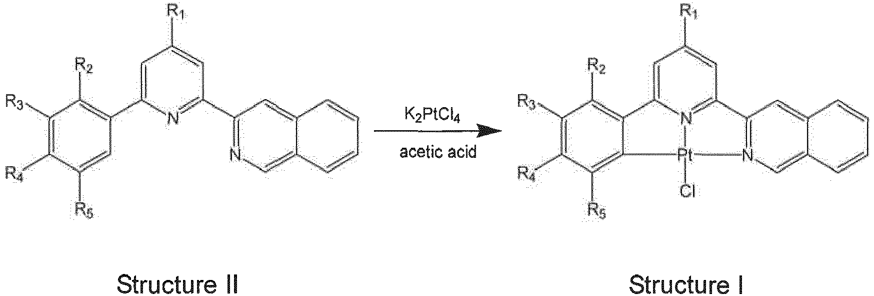 wherein R₁ - R₅ are independently hydrogen, halogen, hydroxyl, an unsubstituted alkyl, a substituted alkyl having substituents which are halogen, alkyl radicals, aryl radicals, heteroaryl radicals, alkenyl radicals, groups which display a +I and/or +M effect or groups which display a -I and/or -M effect, cycloalkyl, an unsubstituted aryl, a substituted aryl having substituents which are halogen, alkyl radicals, aryl radicals, heteroaryl radicals, alkenyl radicals, groups which display a +I and/or +M effect or groups which display a -I and/or -M effect, acyl, alkoxy, acyloxy, amino, nitro, acylamino, aralkyl, cyano, carboxyl, thio, styryl, aminocarbonyl, carbamoyl, aryloxycarbonyl, phenoxycarbonyl, or an alkoxycarbonyl group, with potassium tetrachloroplatinate (K₂PtCl₄), using acetic acid as solvent to form a organometallic complex having a chemical structure of structure I.

13. A compound having the following structure: 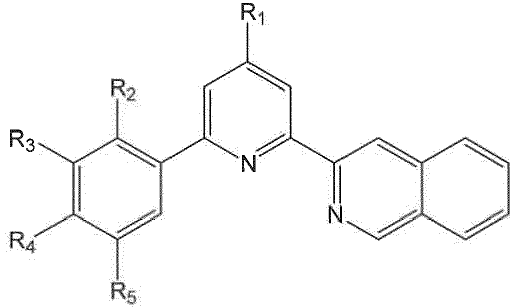 wherein R₁ - R₅ are independently hydrogen, halogen, hydroxyl, an unsubstituted alkyl, a substituted alkyl having substituents which are halogen, alkyl radicals, aryl radicals, heteroaryl radicals, alkenyl radicals, groups which display a +I and/or +M effect or groups which display a -I and/or -M effect, cycloalkyl, an unsubstituted aryl, a substituted aryl having substituents which are halogen, alkyl radicals, aryl radicals, heteroaryl radicals, alkenyl radicals, groups which display a +I and/or +M effect or groups which display a -I and/or -M effect, acyl, alkoxy, acyloxy, amino, nitro, acylamino, aralkyl, cyano, carboxyl, thio, styryl, aminocarbonyl, carbamoyl, aryloxycarbonyl, phenoxycarbonyl, or an alkoxycarbonyl group.

14. A compound having one of the following structures:
| | |
|---|---|
| 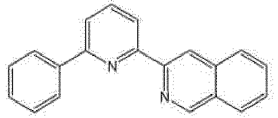 | 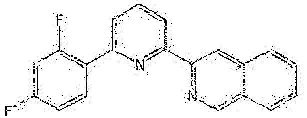 |
| Ligand 1 | Ligand 2 |
| 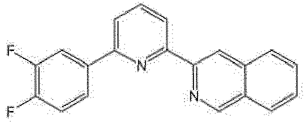 | 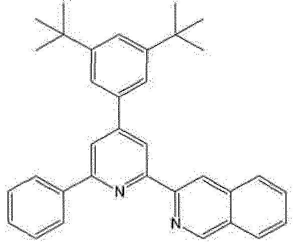 |
| Ligand 3 | Ligand 4 |
| 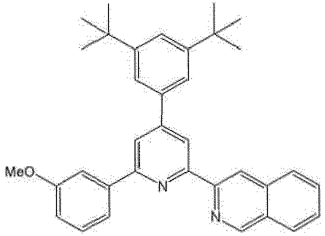 | 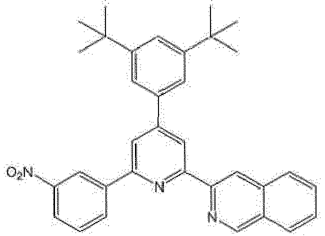 |
| Ligand 5 | Ligand 6 |
| 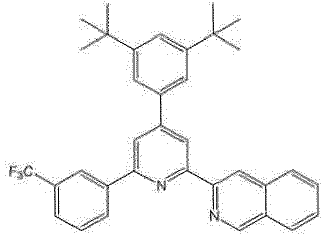 | 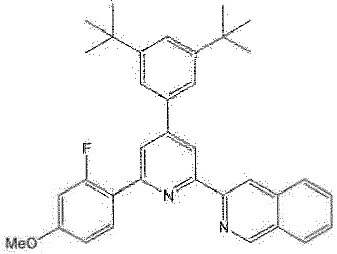 |
| Ligand 7 | Ligand 8 |
| 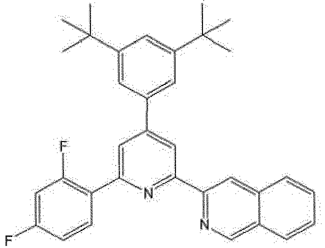 | 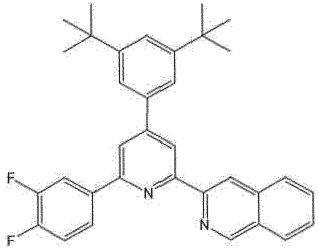 |
| Ligand 9 | Ligand 10 |
| 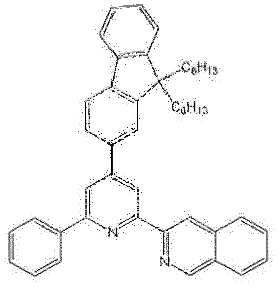 | 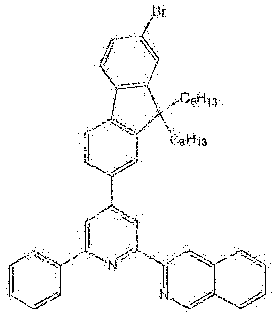 |
| Ligand 11 | Ligand 12 |
| 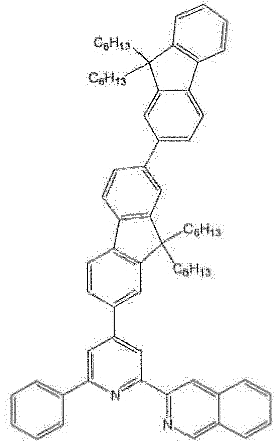 | |
| Ligand 13 | |

15. A method for making an organic light emitting device comprising steps of:
reacting a ligand having the following structure: 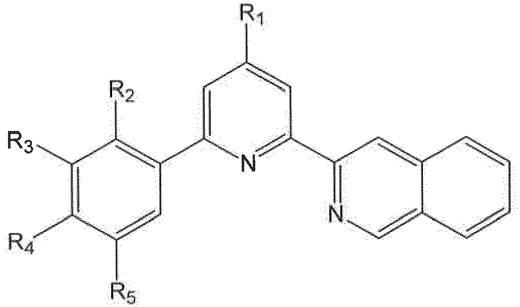 wherein R₁ - R₅ are independently hydrogen, halogen, hydroxyl, an unsubstituted alkyl, a substituted alkyl having substituents which are halogen, alkyl radicals, aryl radicals, heteroaryl radicals, alkenyl radicals, groups which display a +I and/or +M effect or groups which display a -I and/or -M effect, cycloalkyl, an unsubstituted aryl, a substituted aryl having substituents which are halogen, alkyl radicals, aryl radicals, heteroaryl radicals, alkenyl radicals, groups which display a +I and/or +M effect or groups which display a -I and/or -M effect, acyl, alkoxy, acyloxy, amino, nitro, acylamino, aralkyl, cyano, carboxyl, thio, styryl, aminocarbonyl, carbamoyl, aryloxycarbonyl, phenoxycarbonyl, or an alkoxycarbonyl group, with potassium tetrachloroplatinate (K₂PtCl₄), to obtain a platinum complex; and applying a layer of the complex as an emission layer of a light emitting device or doping the complex in an emission layer of a light emitting device.

## Patentansprüche

1. Metallorganischer Komplex mit einer chemischen Struktur gemäß Struktur I: 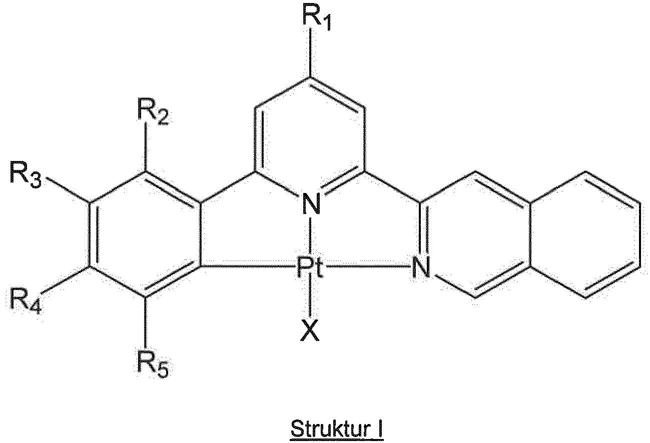 worin R₁ bis R₅ unabhängig voneinander Wasserstoff, Halogen, Hydroxyl, ein unsubstituiertes Alkyl, ein substituiertes Alkyl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Cycloalkyl, ein unsubstituiertes Aryl, ein substituiertes Aryl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Acyl, Alkoxy, Acyloxy, Amino, Nitro, Acylamino, Aralkyl, Cyano, Carboxyl, Thio, Styryl, Aminocarbonyl, Carbamoyl, Aryloxycarbonyl, Phenoxycarbonyl oder eine Alkoxycarbonylgruppe darstellen; X ein Halogen darstellt, 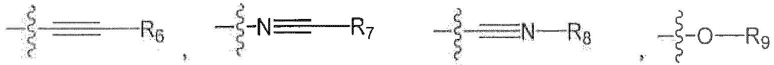 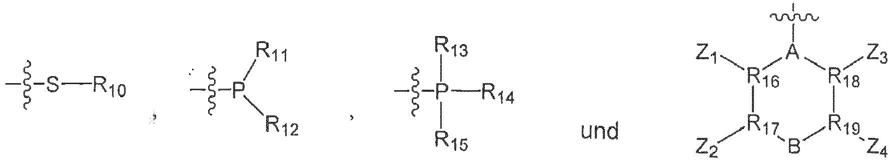 worin A Kohlenstoff, Stickstoff, Sauerstoff, Silicium, Phosphor, Schwefel, Arsen und Selen darstellt; B eine chemische Bindung darstellt, die R₁₇ und R₁₉ verbindet, 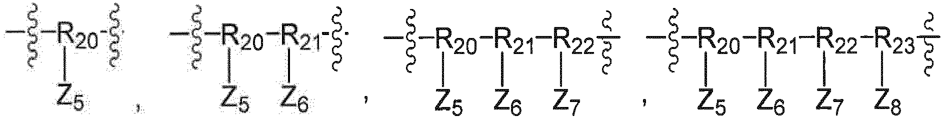 R₆ bis R₁₅ unabhängig voneinander Wasserstoff, Alkyl, substituiertes Alkyl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Cycloalkyl, Aryl, und eine substituierte Arylgruppe mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen; R₁₆ bis R₂₃ unabhängig voneinander Kohlenstoff, Stickstoff, Sauerstoff, Silicium, Phosphor, Schwefel, Arsen und Selen darstellen; Z₁ bis Z₈ unabhängig voneinander Wasserstoff, Alkyl, substituiertes Alkyl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Cycloalkyl, Aryl, eine substituierte Arylgruppe mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen und Z₁ bis Z₈ mit benachbarten Gruppen 5- bis 7-gliedrige Ringe bilden können.

2. Metallorganischer Komplex nach Anspruch 1, wobei es sich bei der Struktur I um eine der folgenden Verbindungen handelt:
| | |
|---|---|
| 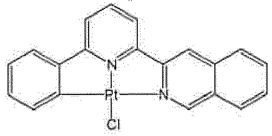 | 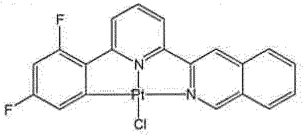 |
| Komplex 1 | Komplex 2 |
| 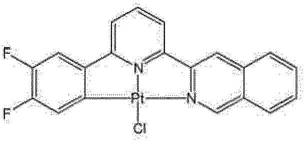 | 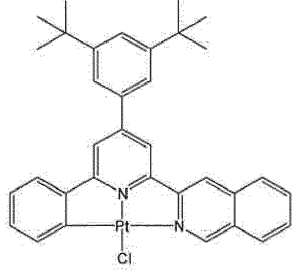 |
| Komplex 3 | Komplex 4 |
| 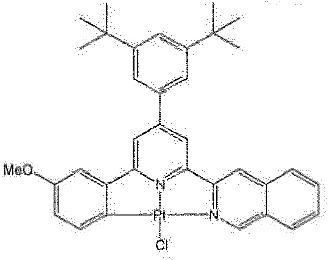 | 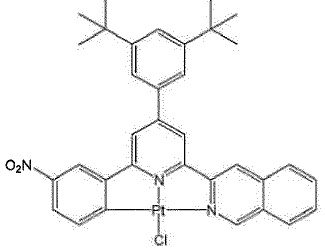 |
| Komplex 5 | Komplex 6 |
| 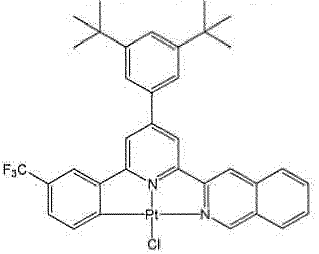 | 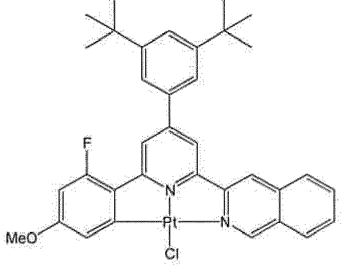 |
| Komplex 7 | Komplex 8 |
| 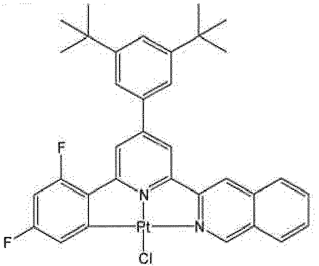 | 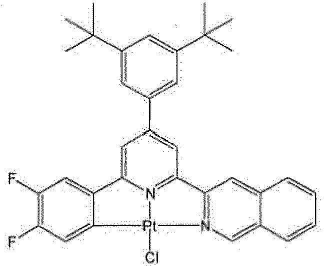 |
| Komplex 9 | Komplex 10 |
| 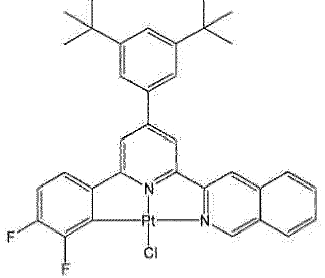 | 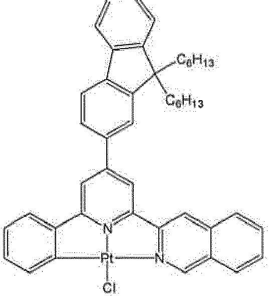 |
| Komplex 11 | Komplex 12 |
| 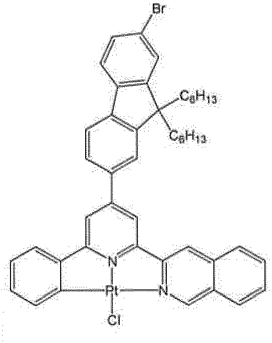 | 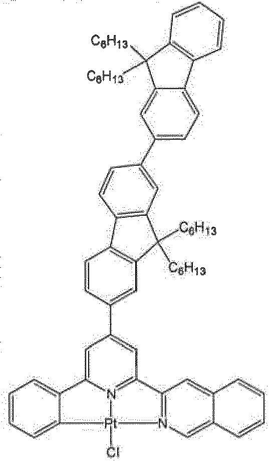 |
| Komplex 13 | Komplex 14 |
| 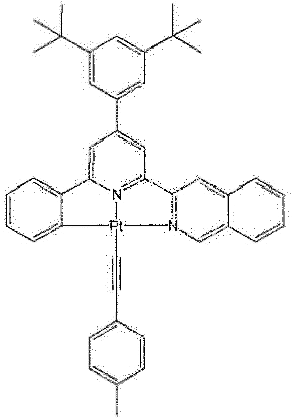 | 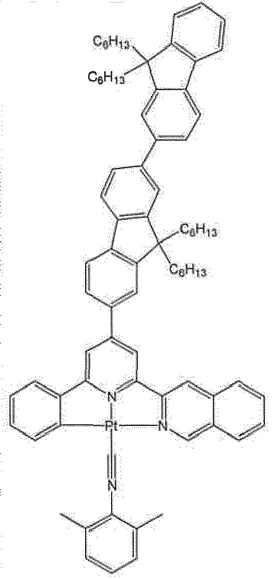 |
| Komplex 15 | Komplex 16 |

3. Organische lichtemittierende Vorrichtung mit einem lichtemittierenden Material, das einen oder mehrere der metallorganischen Komplexe nach Anspruch 1 enthält.

4. Organische lichtemittierende Vorrichtung nach Anspruch 3, wobei der Komplex eine der folgenden Strukturen aufweist:
| | |
|---|---|
| 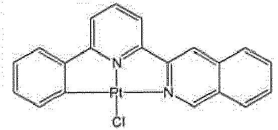 | 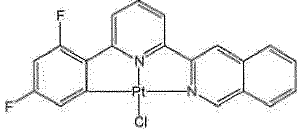 |
| Komplex 1 | Komplex 2 |
| 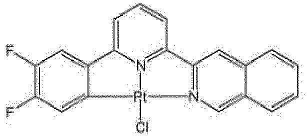 | 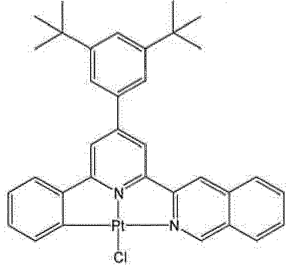 |
| Komplex 3 | Komplex 4 |
| 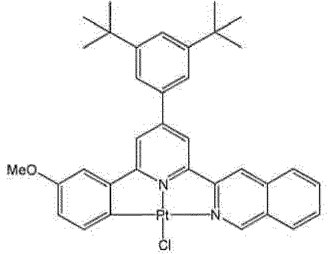 | 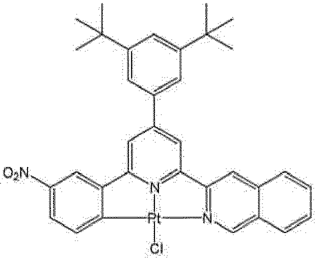 |
| Komplex 5 | Komplex 6 |
| 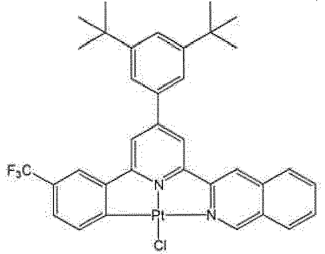 | 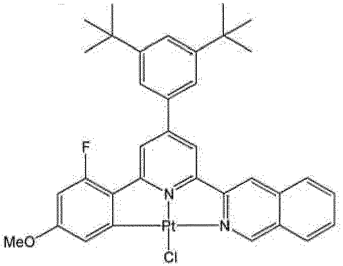 |
| Komplex 7 | Komplex 8 |
| 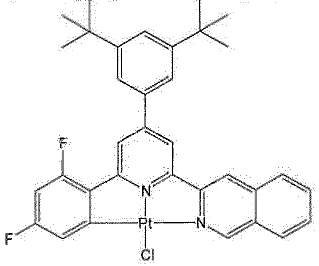 | 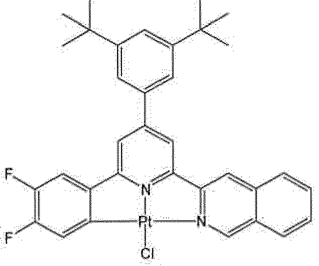 |
| Komplex 9 | Komplex 10 |
| 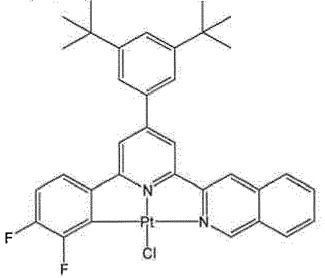 | 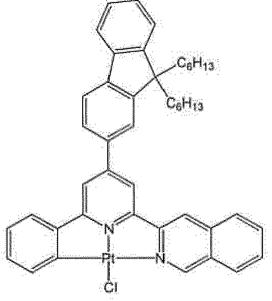 |
| Komplex 11 | Komplex 12 |
| 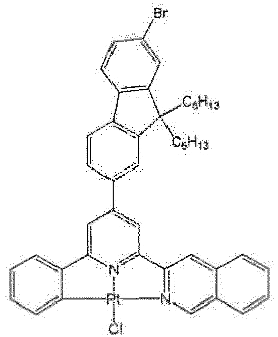 | 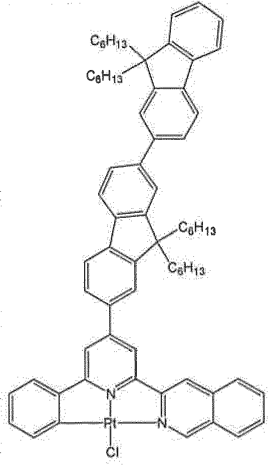 |
| Komplex 13 | Komplex 14 |
| 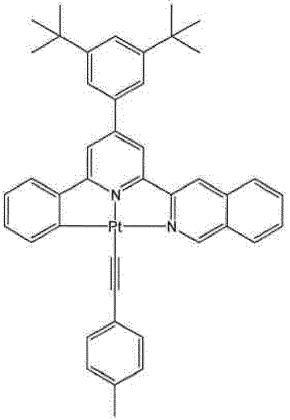 | 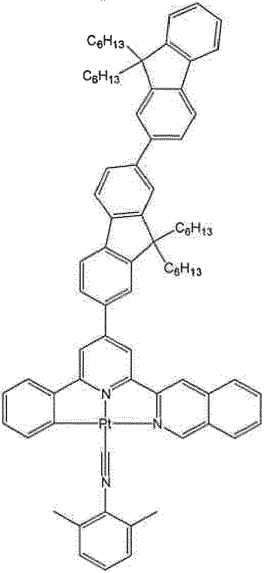 |
| Komplex 15 | Komplex 16 |

5. Organische lichtemittierende Vorrichtung nach Anspruch 3 oder 4, wobei der metallorganische Komplex durch thermisches Aufdampfen als Schicht in der Vorrichtung aufgebracht ist.

6. Organische lichtemittierende Vorrichtung nach einem der Ansprüche 3 bis 5, wobei der metallorganische Komplex durch Spinbeschichten als Schicht in der Vorrichtung aufgebracht ist.

7. Organische lichtemittierende Vorrichtung nach einem der Ansprüche 3 bis 6, wobei der metallorganische Komplex durch Tintenstrahldrucken als Schicht in der Vorrichtung aufgebracht ist.

8. Organische lichtemittierende Vorrichtung nach einem der Ansprüche 3 bis 7, wobei die Vorrichtung eine einzige Farbe emittiert, wenn eine Schicht mit einem elektrischen Strom beaufschlagt wird.

9. Organische lichtemittierende Vorrichtung nach einem der Ansprüche 3 bis 8, wobei die Vorrichtung weißes Licht emittiert, wenn eine Schicht, die einen oder mehrere der metallorganischen Komplexe nach Anspruch 1 oder 2 enthält, mit einem elektrischen Strom beaufschlagt wird und wenn eine oder mehrere Emissionskomponenten aus anderen emittierenden Materialien mit einem elektrischen Strom beaufschlagt wird/werden.

10. Organische lichtemittierende Vorrichtung, umfassend:
ein transparentes Substrat,
eine transparente Elektrode,
eine Lochleitungsschicht,
eine Emissionsschicht, die ein Hostmaterial umfasst, das mit mindestens einem der metallorganischen Komplexe nach Anspruch 1 oder 2 dotiert ist,
eine Lochsperrschicht,
eine Elektronenleitungsschicht,
eine Ladungsinjektionsschicht und
eine Elektrode.

11. Organische lichtemittierende Vorrichtung, umfassend:
ein transparentes Substrat,
eine transparente Elektrode,
eine Lochleitungsschicht,
eine Emissionsschicht, die ein Hostmaterial umfasst, das mit mindestens einem der metallorganischen Komplexe nach Anspruch 1 oder 2 dotiert ist,
eine Lochleitungsschicht,
eine Emissionsschicht, die ein blaues bis himmelblaues Emissionsmaterial umfasst,
eine Lochsperrschicht,
eine Ladungsinjektionsschicht und
eine Elektrode.

12. Verfahren zur Ausbildung eines metallorganischen Komplexes nach Anspruch 1, umfassend:
Umsetzen des entsprechenden Liganden, wie in der nachfolgenden Struktur II angegeben: 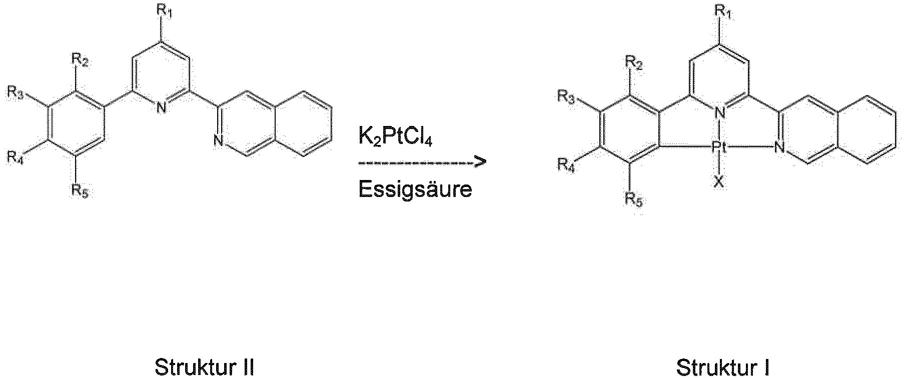 worin R₁ bis R₅ unabhängig voneinander Wasserstoff, Halogen, Hydroxyl, ein unsubstituiertes Alkyl, ein substituiertes Alkyl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Cycloalkyl, ein unsubstituiertes Aryl, ein substituiertes Aryl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Acyl, Alkoxy, Acyloxy, Amino, Nitro, Acylamino, Aralkyl, Cyano, Carboxyl, Thio, Styryl, Aminocarbonyl, Carbamoyl, Aryloxycarbonyl, Phenoxycarbonyl oder eine Alkoxycarbonylgruppe darstellen, mit Kaliumtetrachlorplatinat (K₂PtCl₄) unter Verwendung von Essigsäure als Lösungsmittel zur Bildung eines metallorganischen Komplexes mit einer chemischen Struktur gemäß Struktur I.

13. Verbindung mit der folgenden Struktur: 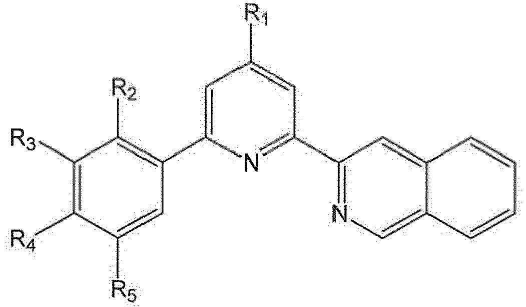 worin R₁ bis R₅ unabhängig voneinander Wasserstoff, Halogen, Hydroxyl, ein unsubstituiertes Alkyl, ein substituiertes Alkyl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Cycloalkyl, ein unsubstituiertes Aryl, ein substituiertes Aryl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Acyl, Alkoxy, Acyloxy, Amino, Nitro, Acylamino, Aralkyl, Cyano, Carboxyl, Thio, Styryl, Aminocarbonyl, Carbamoyl, Aryloxycarbonyl, Phenoxycarbonyl oder eine Alkoxycarbonylgruppe darstellen.

14. Verbindung mit einer der folgenden Strukturen:
| | |
|---|---|
| 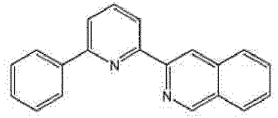 | 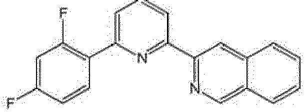 |
| Ligand 1 | Ligand 2 |
| 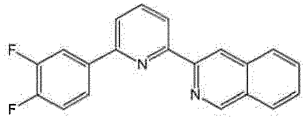 | 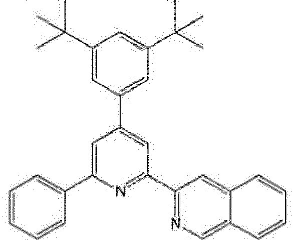 |
| Ligand 3 | Ligand 4 |
| 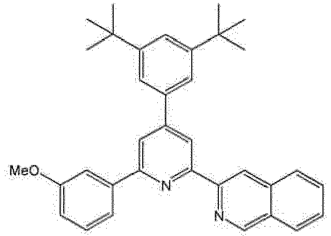 | 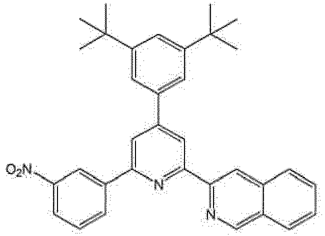 |
| Ligand 5 | Ligand 6 |
| 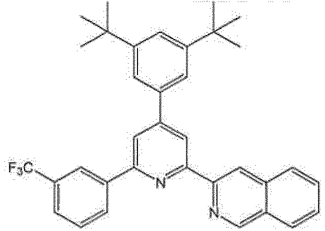 | 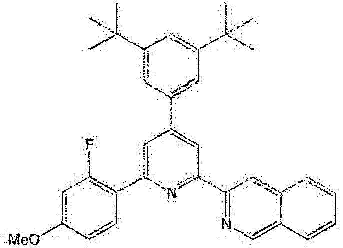 |
| Ligand 7 | Ligand 8 |
| 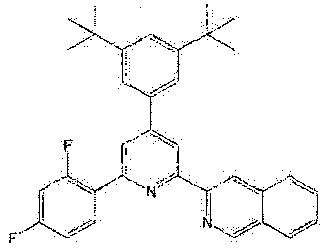 | 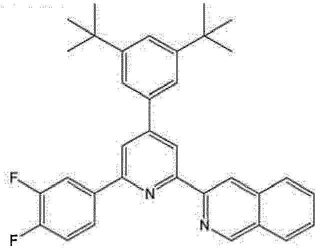 |
| Ligand 9 | Ligand 10 |
| 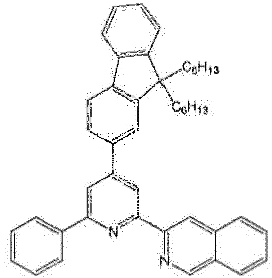 | 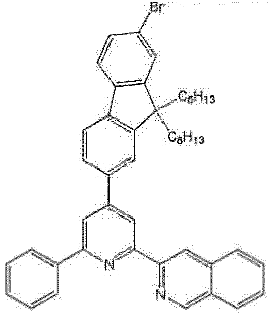 |
| Ligand 11 | Ligand 12 |
| 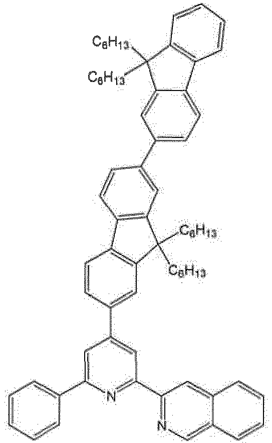 | |
| Ligand 13 | |

15. Verfahren zur Ausbildung einer organischen lichtemittierenden Vorrichtung, umfassend die Schritte:
Umsetzen eines Liganden, der die folgende Struktur aufweist: 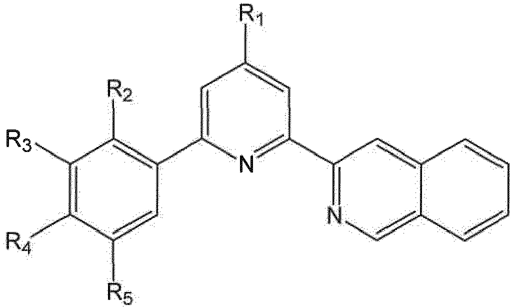 worin R₁ bis R₅ unabhängig voneinander Wasserstoff, Halogen, Hydroxyl, ein unsubstituiertes Alkyl, ein substituiertes Alkyl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Cycloalkyl, ein unsubstituiertes Aryl, ein substituiertes Aryl mit Substituenten, die Halogen, Alkylradikale, Arylradikale, Heteroarylradikale, Alkenylradikale, Gruppen, die einen +I-Effekt und/oder +M-Effekt zeigen, oder Gruppen, die einen -I-Effekt und/oder -M-Effekt zeigen, darstellen, Acyl, Alkoxy, Acyloxy, Amino, Nitro, Acylamino, Aralkyl, Cyano, Carboxyl, Thio, Styryl, Aminocarbonyl, Carbamoyl, Aryloxycarbonyl, Phenoxycarbonyl oder eine Alkoxycarbonylgruppe darstellen, mit Kaliumtetrachlorplatinat (K₂PtCl₄) zur Bildung eines Platinkomplexes, und Aufbringen einer Schicht des Komplexes als Emissionsschicht einer lichtemittierenden Vorrichtung oder Dotieren des Komplexes in eine Emissionsschicht einer lichtemittierenden Vorrichtung.

## Revendications

1. Complexe organométallique ayant une structure chimique de structure I : 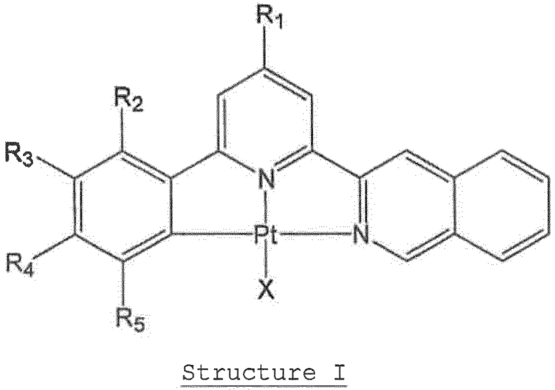 dans laquelle
R₁-R₅ sont chacun indépendamment l'atome d'hydrogène, un atome d'halogène, un groupe hydroxyle, un groupe alkyle non substitué, un groupe alkyle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe cycloalkyle, un groupe aryle non substitué, un groupe aryle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe acyle, un groupe alcoxy, un groupe acyloxy, un groupe amino, un groupe nitro, un groupe acylamino, un groupe aralkyle, un groupe cyano, un groupe carboxyle, un groupe thio, un groupe styryle, un groupe aminocarbonyle, un groupe carbamoyle, un groupe aryloxycarbonyle, un groupe phénoxycarbonyle ou un groupe alcoxycarbonyle ;
X est un atome d'halogène, 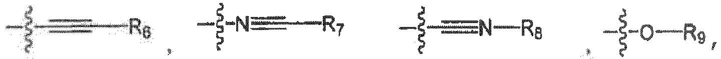 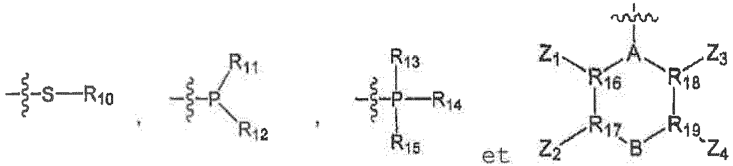
A étant un atome de carbone, d'azote, d'oxygène, de silicium, de phosphore, de soufre, d'arsenic et de sélénium ;
B étant une liaison chimique reliant R₁₇ et R₁₉, 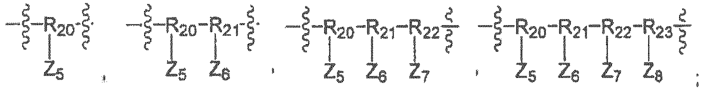
R₆-R₁₅ étant chacun indépendamment l'atome d'hydrogène, un groupe alkyle, un groupe alkyle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe cycloalkyle, un groupe aryle et un groupe aryle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M ;
R₁₆-R₂₃ étant chacun indépendamment un atome de carbone, d'azote, d'oxygène, de silicium, de phosphore, de soufre, d'arsenic et de sélénium ;
Z₁-Z₈ étant chacun indépendamment l'atome d'hydrogène, un groupe alkyle, un groupe alkyle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe cycloalkyle, un groupe aryle, un groupe aryle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M et Z₁-Z₈ pouvant former avec des groupes voisins un ou plusieurs cycles à 5-7 chaînons.

2. Complexe organométallique selon la revendication 1 dans lequel la structure I est l'un des composés suivants :
| | |
|---|---|
| 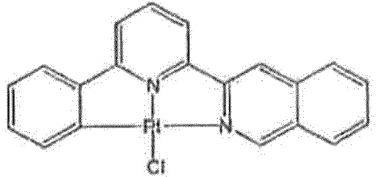 | 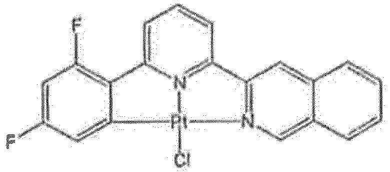 |
| Complexe 1 | Complexe 2 |
| 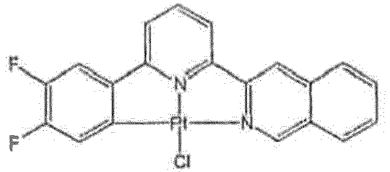 | 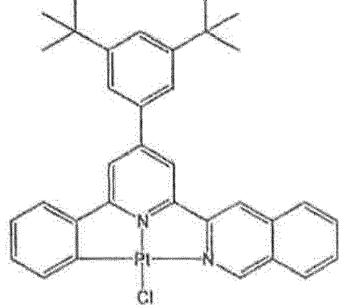 |
| Complexe 3 | Complexe 4 |
| 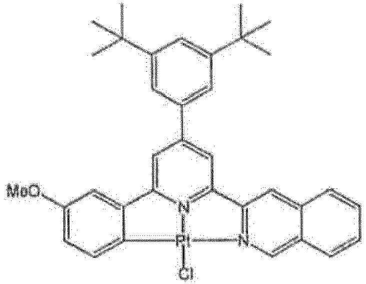 | 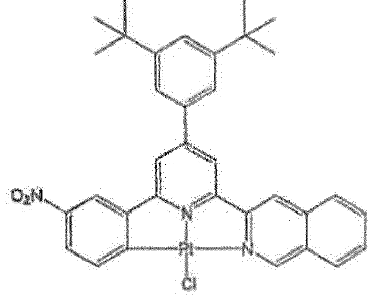 |
| Complexe 5 | Complexe 6 |
| 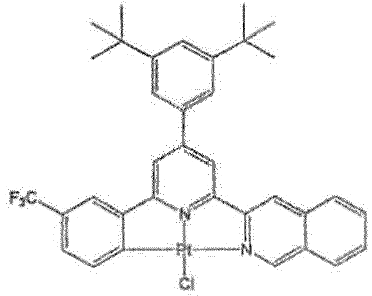 | 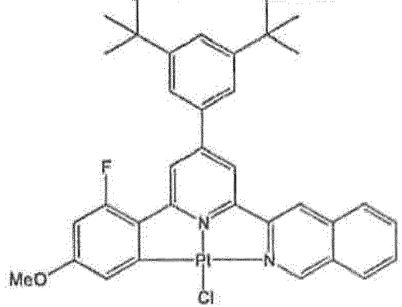 |
| Complexe 7 | Complexe 8 |
| 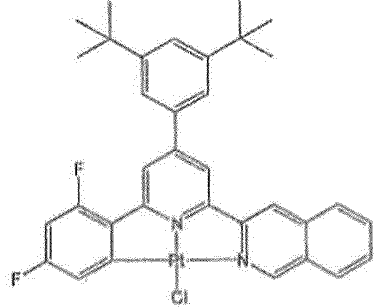 | 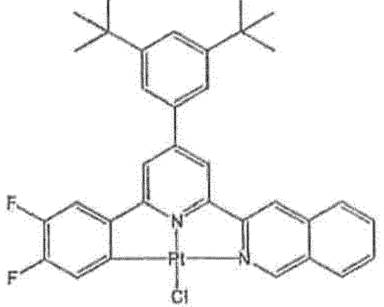 |
| Complexe 9 | Complexe 10 |
| 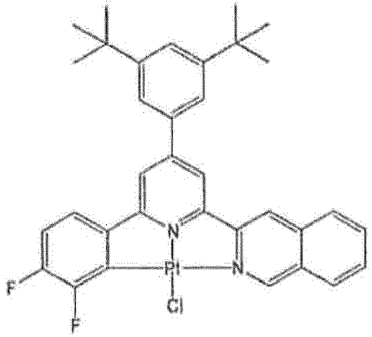 | 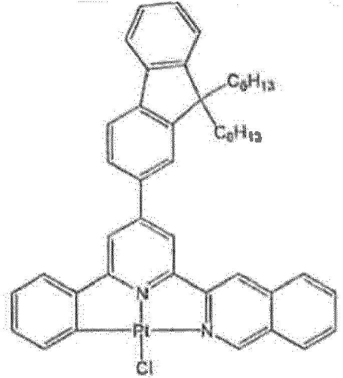 |
| Complexe 11 | Complexe 12 |
| 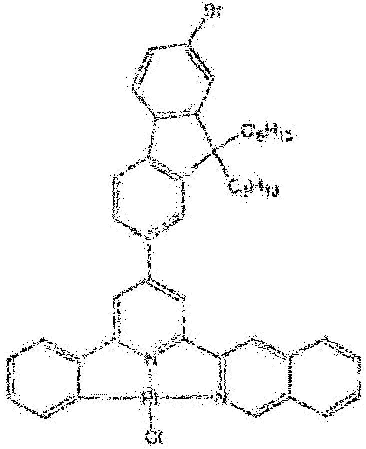 | 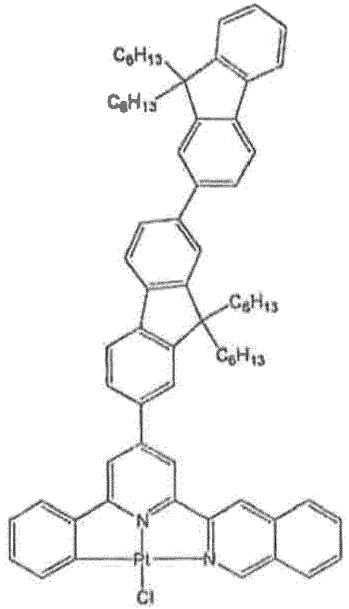 |
| Complexe 13 | Complexe 14 |
| 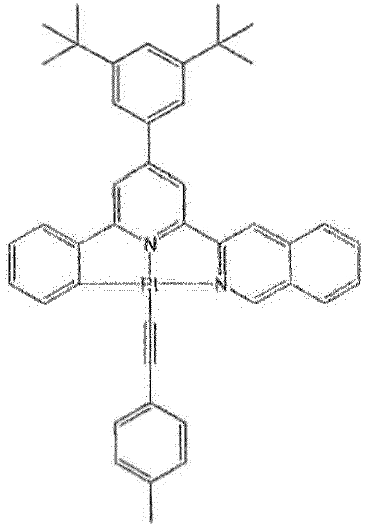 | 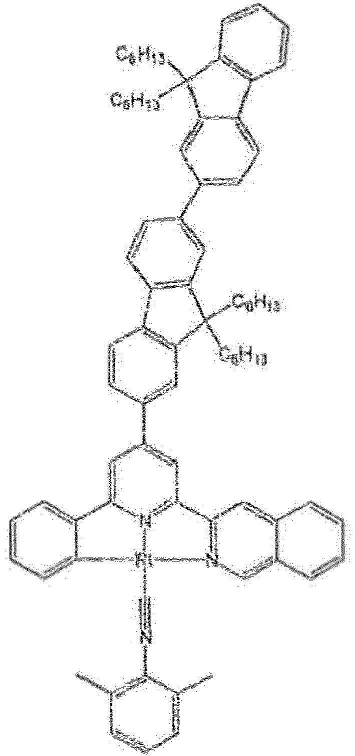 |
| Complexe 15 | Complexe 16 |

3. Dispositif électroluminescent organique comprenant un matériau électroluminescent contenant un ou plusieurs des complexes organométalliques exposés dans la revendication 1.

4. Dispositif électroluminescent organique tel qu'exposé dans la revendication 3, dans lequel le complexe a l'une des structures suivantes :
| | |
|---|---|
| 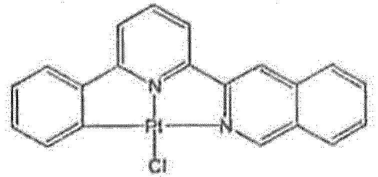 | 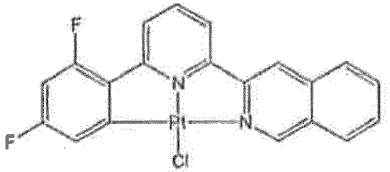 |
| Complexe 1 | Complexe 2 |
| 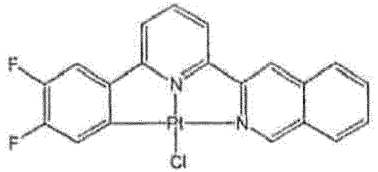 | 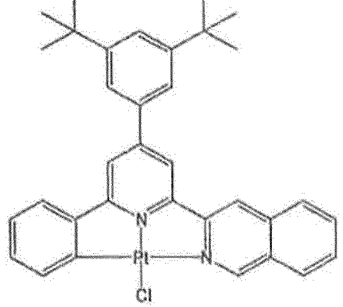 |
| Complexe 3 | Complexe 4 |
| 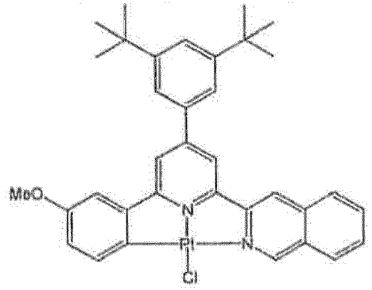 | 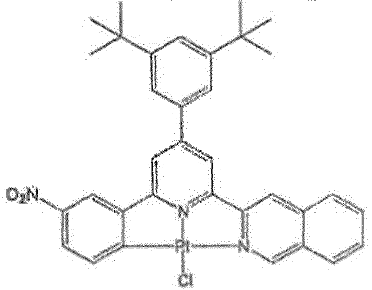 |
| Complexe 5 | Complexe 6 |
| 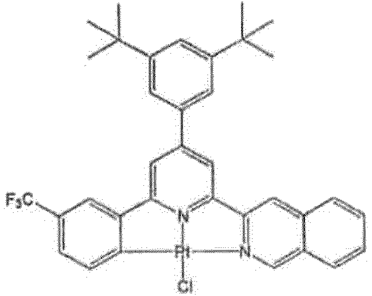 | 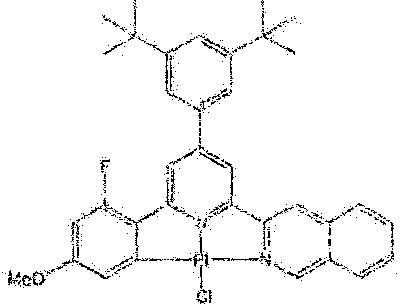 |
| Complexe 7 | Complexe 8 |
| 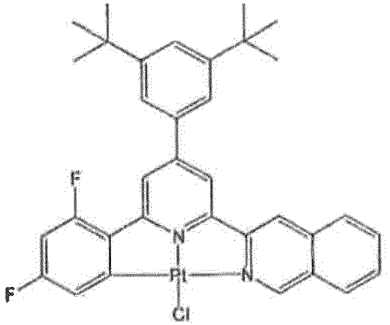 | 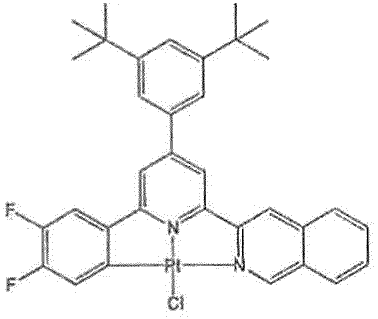 |
| Complexe 9 | Complexe 10 |
| 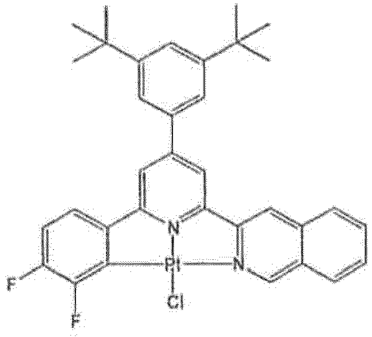 | 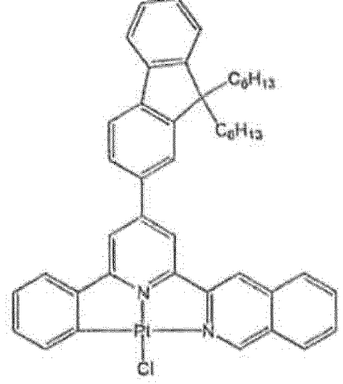 |
| Complexe 11 | Complexe 12 |
| 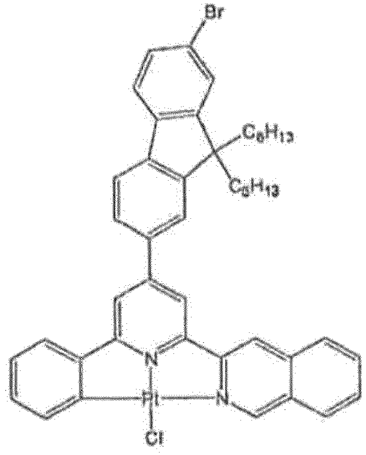 | 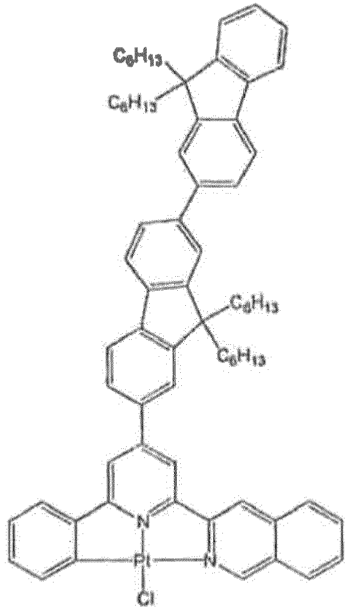 |
| Complexe 13 | Complexe 14 |
| 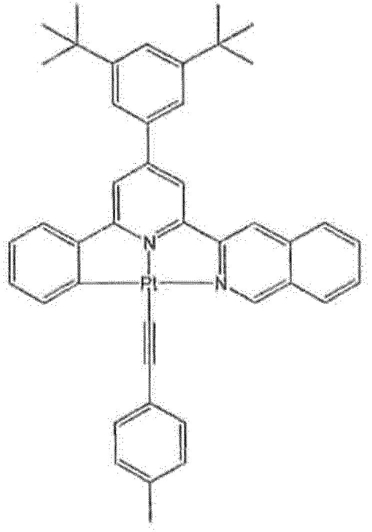 | 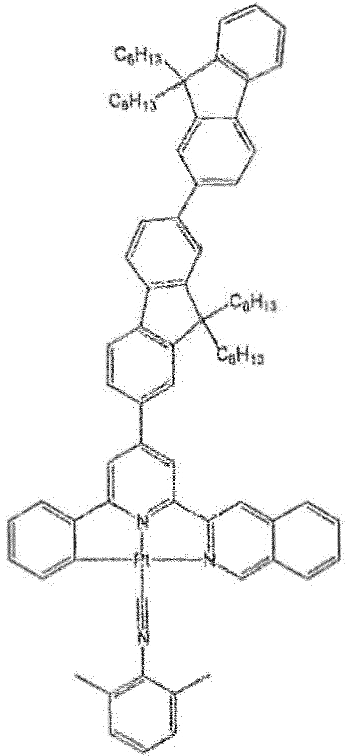 |
| Complexe 15 | Complexe 16. |

5. Dispositif électroluminescent organique tel qu'exposé dans la revendication 3 ou 4, le complexe organométallique étant appliqué sous forme d'une couche dans le dispositif par dépôt thermique.

6. Dispositif électroluminescent organique tel qu'exposé dans l'une quelconque des revendications 3 à 5, le complexe organométallique étant appliqué sous forme d'une couche dans le dispositif par dépôt à la tournette.

7. Dispositif électroluminescent organique tel qu'exposé dans l'une quelconque des revendications 3 à 6, le complexe organométallique étant appliqué sous forme d'une couche dans le dispositif par impression par jet d'encre.

8. Dispositif électroluminescent organique tel qu'exposé dans l'une quelconque des revendications 3 à 7, le dispositif émettant une seule couleur lorsqu'un courant électrique est appliqué à une couche.

9. Dispositif électroluminescent organique tel qu'exposé dans l'une quelconque des revendications 3 à 8, le dispositif émettant de la lumière blanche lorsqu'un courant électrique est appliqué à une couche contenant le ou les complexes organométalliques tels qu'exposés dans la revendication 1 ou 2 et lorsqu'un courant électrique est appliqué à un ou plusieurs composants d'émission à partir d'autres matériaux émetteurs.

10. Dispositif électroluminescent organique comprenant :
un substrat transparent ;
une électrode transparente ;
une couche de transport de trous ;
une couche émettrice comprenant un matériau hôte dopé avec au moins l'un des complexes organométalliques tels qu'exposés dans la revendication 1 ou 2 ;
une couche de blocage de trous ;
une couche de transport d'électrons ;
une couche d'injection de charges ; et
une électrode.

11. Dispositif électroluminescent organique comprenant :
un substrat transparent ;
une électrode transparente ;
une couche de transport de trous ;
une couche émettrice comprenant un matériau hôte dopé avec au moins l'un des complexes organométalliques tels qu'exposés dans la revendication 1 ou 2 ;
une couche de transport de trous ;
une couche émettrice comprenant un matériau émettant du bleu au bleu ciel ;
une couche de blocage de trous ;
une couche d'injection de charges ; et
une électrode.

12. Procédé de fabrication d'un complexe organométallique selon la revendication 1 comprenant :
la réaction du ligand correspondant identifié comme étant la structure II ci-dessous : 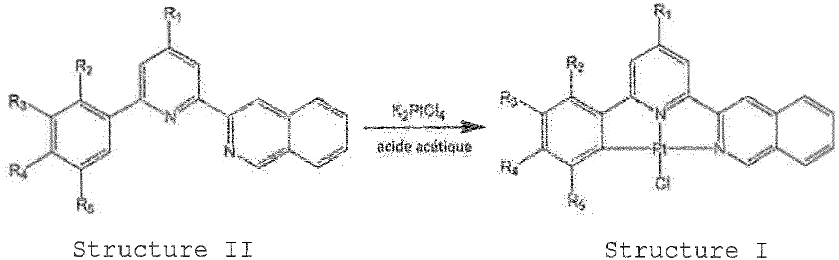 dans laquelle R₁-R₅ sont chacun indépendamment l'atome d'hydrogène, un atome d'halogène, un groupe hydroxyle, un groupe alkyle non substitué, un groupe alkyle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe cycloalkyle, un groupe aryle non substitué, un groupe aryle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe acyle, un groupe alcoxy, un groupe acyloxy, un groupe amino, un groupe nitro, un groupe acylamino, un groupe aralkyle, un groupe cyano, un groupe carboxyle, un groupe thio, un groupe styryle, un groupe aminocarbonyle, un groupe carbamoyle, un groupe aryloxycarbonyle, un groupe phénoxycarbonyle ou un groupe alcoxycarbonyle, avec du tétrachloroplatinate de potassium (K₂PtCl₄), à l'aide d'acide acétique en tant que solvant pour former un complexe organométallique ayant une structure chimique de structure I.

13. Composé ayant la structure suivante : 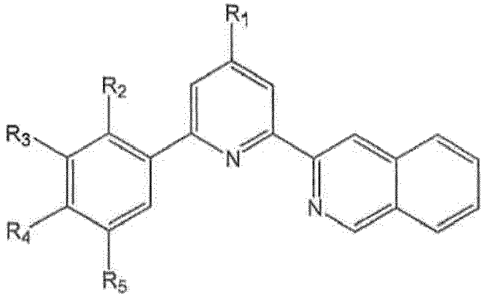 dans laquelle R₁-R₅ sont chacun indépendamment l'atome d'hydrogène, un atome d'halogène, un groupe hydroxyle, un groupe alkyle non substitué, un groupe alkyle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe cycloalkyle, un groupe aryle non substitué, un groupe aryle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe acyle, un groupe alcoxy, un groupe acyloxy, un groupe amino, un groupe nitro, un groupe acylamino, un groupe aralkyle, un groupe cyano, un groupe carboxyle, un groupe thio, un groupe styryle, un groupe aminocarbonyle, un groupe carbamoyle, un groupe aryloxycarbonyle, un groupe phénoxycarbonyle ou un groupe alcoxycarbonyle.

14. Composé ayant l'une des structures suivantes :
| | |
|---|---|
| 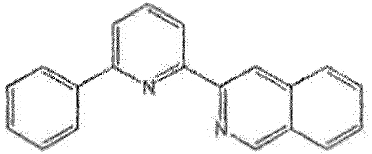 | 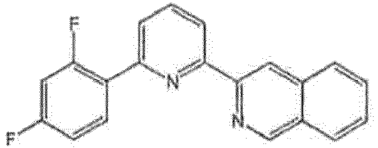 |
| Ligand 1 | Ligand 2 |
| 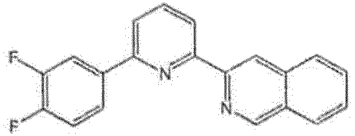 | 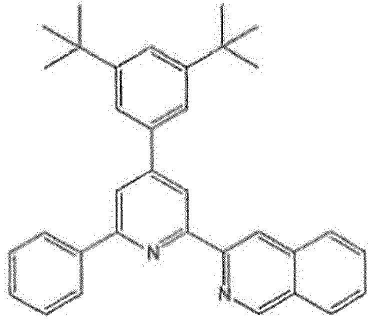 |
| Ligand 3 | Ligand 4 |
| 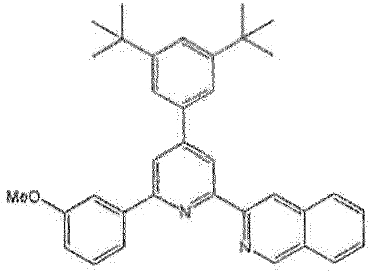 | 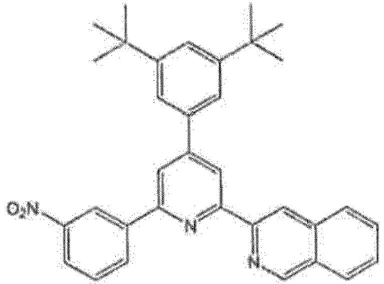 |
| Ligand 5 | Ligand 6 |
| 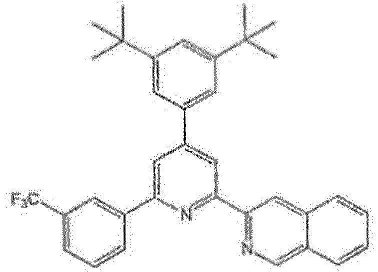 | 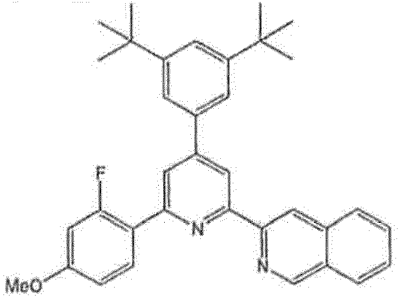 |
| Ligand 7 | Ligand 8 |
| 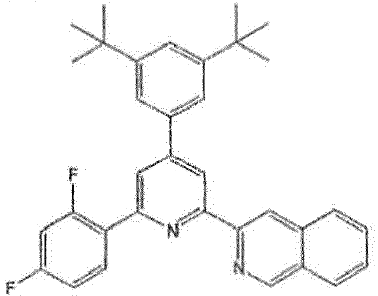 | 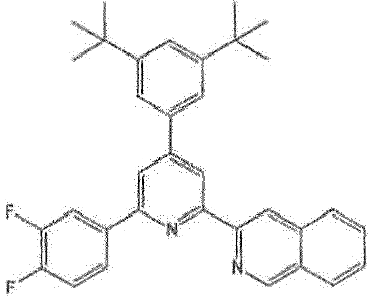 |
| Ligand 9 | Ligand 10 |
| 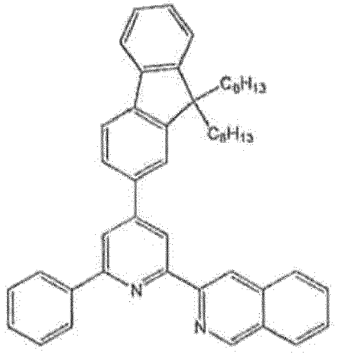 | 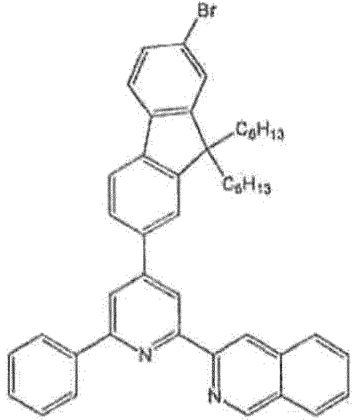 |
| Ligand 11 | Ligand 12 |
| 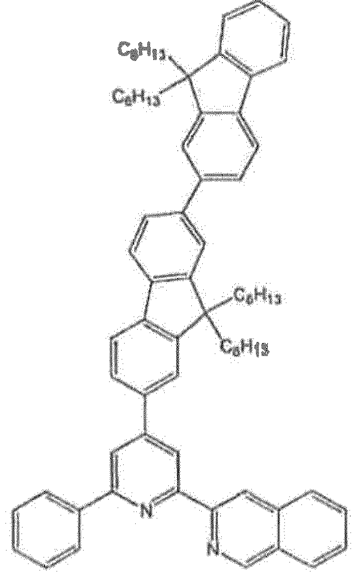 | |
| Ligand 13. | |

15. Procédé pour la fabrication d'un dispositif électroluminescent organique comprenant les étapes consistant à :
faire réagir un ligand ayant la structure suivante : 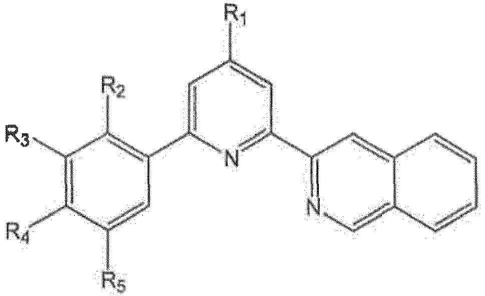 dans laquelle R₁-R₅ sont chacun indépendamment l'atome d'hydrogène, un atome d'halogène, un groupe hydroxyle, un groupe alkyle non substitué, un groupe alkyle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe cycloalkyle, un groupe aryle non substitué, un groupe aryle substitué ayant des substituants qui sont des atomes d'halogène, des radicaux alkyle, des radicaux aryle, des radicaux hétéroaryle, des radicaux alcényle, des groupes qui présentent un effet +I et/ou +M ou des groupes qui présentent un effet -I et/ou -M, un groupe acyle, un groupe alcoxy, un groupe acyloxy, un groupe amino, un groupe nitro, un groupe acylamino, un groupe aralkyle, un groupe cyano, un groupe carboxyle, un groupe thio, un groupe styryle, un groupe aminocarbonyle, un groupe carbamoyle, un groupe aryloxycarbonyle, un groupe phénoxycarbonyle ou un groupe alcoxycarbonyle, avec du tétrachloroplatinate de potassium (K₂PtCl₄) pour obtenir un complexe du platine ; et
appliquer une couche du complexe en tant que couche d'émission d'un dispositif électroluminescent ou doper une couche d'émission d'un dispositif électroluminescent avec le complexe.
